# EUROPÄISCHE PATENTSCHRIFT

(11) **EP 3 868 925 B1**
(45) Veröffentlichungstag und Bekanntmachung des Hinweises auf die Patenterteilung: **18.11.2026**
(21) Anmeldenummer: 21154762.5
(22) Anmeldetag: 02.02.2021
(51) Int. Cl.: C30B 23/02, C30B 35/00, C30B 29/36, C30B 23/00, C23C 14/06, C30B 29/40, C30B 29/16

(54) **VERFAHREN ZUR HERSTELLUNG EINES EINKRISTALLS IN EINEM WACHSTUMSTIEGEL**
METHOD FOR PRODUCING A SINGLE CRYSTAL IN A GROWTH CRUCIBLE
PROCÉDÉ DE FABRICATION D'UN CRISTAL UNIQUE DANS UN CREUSET DE CROISSANCE

(30) Priorität: 18.02.2020 DE 102020104226
(43) Veröffentlichungstag der Anmeldung: 25.08.2021
(73) Patentinhaber: Friedrich-Alexander-Universität Erlangen-Nürnberg, in Vertretung des Freistaates Bayern, 91058 Erlangen (DE)
(72) Erfinder: Wellmann, Peter, 90425 Nürnberg (DE)
(74) Vertreter: Louis Pöhlau Lohrentz

(56) Entgegenhaltungen:
- EP-A1- 1 567 696
- EP-B1- 1 567 696
- JP-A- 2000 264 795
- JP-A- H11 255 597
- US-A1- 2014 190 413
- SEO SEUNG-KUK ET AL: "Thermal Emissivity of Nuclear Graphite as a Function of Its Oxidation Degree (1) -Effects of Density, Porosity, and Microstructure-", CARBON LETTERS, vol. 10, no. 3, 30 September 2009 (2009-09-30), pages 225 - 229, XP093181857, ISSN: 1976-4251, DOI: 10.5714/CL.2009.10.3.225
- ANONYMOUS: "Thermal emissivity Measurement", 7 August 2020 (2020-08-07), XP093181827, Retrieved from the Internet <URL:https://themacs-engineering.com/wp-content/uploads/2020/05/Emissivity-measurement.pdf> [retrieved on 20240403]
- AUTIO G ET AL: "The normal spectral emissivity of isotropic and anisotropic materials", CARBON, ELSEVIER OXFORD, GB, vol. 4, no. 1, 1 May 1966 (1966-05-01), pages 13 - 28, XP022844880, ISSN: 0008-6223, [retrieved on 19660501], DOI: 10.1016/0008-6223(66)90005-4
- BIASETTO L ET AL: "Emissivity measurements of opaque gray bodies up to 2000 Â°C by a dual-frequency pyrometer", THE EUROPEAN PHYSICAL JOURNAL A ; HADRONS AND NUCLEI, SOCIETÀ ITALIANA DI FISICA, BO, vol. 38, no. 2, 6 November 2008 (2008-11-06), pages 167 - 171, XP019635741, ISSN: 1434-601X, DOI: 10.1140/EPJA/I2008-10666-6

## Beschreibung

Die Erfindung betrifft ein Verfahren zur Herstellung eines Einkristalls in einem Wachstumstiegel. Das Verfahren wird insbesondere zur Vergrößerung eines Einkristalls in einem Wachstumstiegel durchgeführt. Weiterhin betrifft die Erfindung einen Wachstumstiegel zur Herstellung und/oder Vergrößerung eines Einkristalls.

Nach dem Stand der Technik werden zahlreiche Einkristalle für die Anwendung in elektronischen Bauelementen oder zur Nutzung als Schmucksteine durch Verdampfen eines Quellenmaterials bei hohen Temperaturen und durch Abscheidung oder Kristallisation an einer etwas kälteren Stelle nach dem sogenannten PVT-Verfahren (englisch für "physical vapor transport") hergestellt.

Die Grundlagen zur Herstellung von Einkristallen aus Siliziumkarbid mittels des PVT-Verfahrens sind aus der wissenschaftlichen Veröffentlichung Yu. M. Tairov, V. F. Tsvetkov, Investigation of Growth Processes of Ingots of Silicon Carbide Single Crystals, Journal of Crystal Growth 43 (1978) 209 - 212 bekannt. Eine Übersicht zur aktuellen Forschung in Bezug auf die Herstellung von Einkristallen am Beispiel von Siliziumkarbid geht aus der wissenschaftlichen Veröffentlichung P. J. Wellmann, Review of SiC crystal growth technology, Semiconductor Science and Technology 33, 103001 hervor.

Bei Verfahren nach dem Stand der Technik kann die Wachstumsgeschwindigkeit und die Wachstumskinetik nur mit begrenzter Genauigkeit eingestellt werden. Dies führt insbesondere bei der Herstellung von großen Einkristallen zu Schwierigkeiten.

Die japanische Patentanmeldung JP H11 255 597 A betrifft einen Wachstumstiegel zur Herstellung von SiC-Einkristallen. Dabei ist eine Abschirmplatte zwischen dem Quellenmaterial und dem Einkristall vorgesehen. Die Abschirmplatte soll die auf einen mittleren Bereich des Einkristalls gerichtete Wärmestrahlung abfangen und dadurch ein thermisches Abtragen des mittleren Bereichs des Einkristalls verhindern.

Die europäische Patentanmeldung EP 1 567 696 A1 betrifft einen Wachstumstiegel zur Herstellung von AIN-Einkristallen. Dabei ist eine Ausgestaltung des Wachstumstiegels mit einer im Gasraum zwischen Quellenmaterial und AIN-Einkristall angeordneter Diffusionsmembran aus einem gasdurchlässigen Tiegelmaterial bekannt.

Die japanische Patentanmeldung JP 2000- 264 795 A betrifft einen Wachstumstiegel zur Herstellung von SiC-Einkristallen. Der bekannte Wachstumstiegel weist eine Abschirmplatte aus beispielsweise porösem Graphit im Gasraum zwischen dem Quellenmaterial und dem SiC-Einkristall auf.

Aus der US-amerikanischen Patentanmeldung US 2014 / 0 190 413 A1 ist ein Wachstumstiegel zur Herstellung von Einkristallen bekannt. Der Wachstumstiegel enthält ein Ausgleichelement zum Ausgleichen von Temperaturunterschieden am Quellenmaterial. Das Ausgleichelement ist von einer Vielzahl von axial verlaufenden Löchern mit jeweils einem hexagonalen Querschnitt durchsetzt und gliedert sich in einen länglichen zentralen Bereich und zwei seitlich vom zentralen Bereich angeordnete Randbereiche. Die Löcher im zentralen Bereich sind wesentlich breiter als die Löcher in den Randbereichen.

Aufgabe der vorliegenden Erfindung ist es, die Nachteile aus dem Stand der Technik zu beseitigen. Insbesondere soll ein Verfahren und ein Wachstumstiegel angegeben werden, mit dem die Wachstumsgeschwindigkeit und die Wachstumskinetik definiert einstellbar sind. Dadurch soll die Qualität bei der Herstellung von großen Einkristallen verbessert werden.

Erfindungsgemäß wird diese Aufgabe durch ein Verfahren gemäß dem Gegenstand des Anspruchs 1 und durch einen Wachstumstiegel gemäß dem Gegenstand des Anspruchs 7 gelöst. Vorteilhafte Ausgestaltungen der Erfindung sind dazu jeweils in den abhängigen Ansprüchen angegeben.

Nach Maßgabe der Erfindung erfolgt das Verfahren durch Steuerung von Temperaturgradienten in einem Wachstumstiegel. Der Wachstumstiegel weist eine zylindrische Form auf. Mit dem erfindungsgemäßen Verfahren werden insbesondere in radialer Richtung verlaufende Temperaturgradienten gesteuert. Die Steuerung der Temperaturgradienten geht vorzugsweise mit einer Steuerung der Wärmeströme innerhalb des Wachstumstiegels einher.

Die Erläuterungen zu der vorliegenden Erfindung nehmen hauptsächlich Bezug auf die Temperaturgradienten. Dabei versteht es sich von selbst, dass es sich um Temperaturgradienten im dreidimensionalen Inneren des Wachstumstiegels handelt. Tatsächlich soll mit der vorliegenden Erfindung das dreidimensionale Temperaturfeld im Inneren des Wachstumstiegels gesteuert und/oder eingestellt werden. Die Erfindung kann in entsprechender Weise verstanden werden, dass die Isothermen, insbesondere der Verlauf der Isothermen, im dreidimensionalen Inneren des Wachstumstiegels gesteuert und/oder eingestellt werden.

Die senkrecht zu den Isothermen verlaufenden Temperaturgradienten haben in der Kristallzüchtung eine wichtige Bedeutung. Entlang der senkrecht zu den Isothermen verlaufenden Temperaturgradienten sind die Gasdruckunterschiede lokal am stärksten ausgeprägt. Daher erfolgt der Stofftransport bzw. der Materialstrom vorzugsweise im Wesentlichen entlang dieser Temperaturgradienten senkrecht zu den Isothermen. Weiterhin verlaufen die Wärmeströme vorzugsweise entlang der senkrecht zu den Isothermen verlaufenden Temperaturgradienten.

Im Inneren des Wachstumstiegels sind ein Quellenmaterial, der Einkristall und ein zwischen dem Quellenmaterial und dem Einkristall vorgesehenes gaspermeables Trennelement mit einer dem Einkristall zugewandten ersten Oberfläche und einer dem Quellenmaterial zugewandten zweiten Oberfläche aufgenommen. Das Innere des Wachstumstiegels weist vorzugsweise eine zylindrische Form oder eine im Wesentlichen zylindrische Form auf. Vorzugsweise sind das Quellenmaterial und der Einkristall an den beiden axial gegenüberliegenden Enden des Inneren des Wachstumstiegels angeordnet. Das Quellenmaterial besteht vorzugsweise aus dem gleichen Material wie der Einkristall. Zwischen der ersten Oberfläche und dem Einkristall befindet sich vorzugsweise ein erster Gasraum. Zwischen der zweiten Oberfläche und dem Quellenmaterial kann sich ein zweiter Gasraum befinden. In diesem Fall sind die zweite Oberfläche und das Quellenmaterial voneinander beabstandet. Alternativ dazu kann sich das Quellenmaterial bis zur zweiten Oberfläche erstrecken. In diesem Fall liegt das gaspermeable Trennelement mit seiner zweiten Oberfläche vorzugsweise auf dem Quellenmaterial auf. Der erste und/oder der zweite Gasraum bilden den Gasraum im Inneren des Wachstumstiegels. Das Quellenmaterial hat vorzugsweise eine im Wesentlichen zylindrische Form. Das Quellenmaterial hat dabei vorzugsweise einen Durchmesser, der dem Innendurchmesser des zylindrischen Wachstumstiegels entspricht. Das Quellenmaterial füllt also vorzugsweise den Wachstumstiegel in radialer Richtung vollständig aus. Der Einkristall hat vorzugsweise eine im Wesentlichen zylindrische Form, insbesondere die Form eines einseitig konvex abgerundeten Zylinders, wobei die konvex abgerundete Seite des Einkristalls dem Quellenmaterial zugewandt ist. Der Einkristall hat vorzugsweise einen Durchmesser, der im Wesentlichen dem Innendurchmesser des Wachstumstiegels entspricht. Der Einkristall kann dabei die Innenseite der Tiegelwand berühren. Alternativ kann der Einkristall ohne direkten Kontakt zur Tiegelwand hergestellt werden. Darüber hinaus kann der Einkristall von einem polykristallinen Ring umgeben sein. Der polykristalline Ring kann an der Innenseite der Tiegelwand anliegen.

Das Quellenmaterial kann insbesondere ein Karbid und/oder ein Nitrid umfassen. Vorzugsweise wird als Quellenmaterial Siliziumkarbid, bzw. als Formel geschrieben SiC, verwendet. Alternativ kann beispielsweise Aluminiumnitrid, das heißt AIN, als Quellenmaterial verwendet werden. Ein weiteres mögliches Quellenmaterial ist Zinkoxid (ZnO). Das Quellenmaterial wird vorzugsweise als Pulver und/oder als massiver Volumenkörper bereitgestellt. Der massive Volumenkörper kann insbesondere polykristallin sein. Vorzugsweise wird dabei ein zu vergrößernder Einkristall zunächst als Keimkristall und/oder Kristallisationskeim an dem dem Quellenmaterial gegenüberliegenden Ende des Inneren des Wachstumstiegels bereitgestellt. Der Keimkristall und/oder Kristallisationskeim hat vorzugsweise einen Durchmesser, der 60 % bis 100 %, vorzugsweise 75 % bis 95 %, des Innendurchmessers des Wachstumstiegels entspricht. Für einen Durchmesser des Keimkristalls und/oder Kristallisationskeims von 150 mm kann beispielsweise der Innendurchmesser des Wachstumstiegels 150 mm bis 200 mm betragen. Der Keimkristall und/oder Kristallisationskeim besteht vorzugsweise aus dem gleichen Material wie das Quellenmaterial. Bei der Verwendung von SiC als Quellenmaterial wird als Keimkristall und/oder Kristallisationskeim vorzugsweise ein SiC-Einkristall bereitgestellt. Bei der Verwendung von AIN als Quellenmaterial wird als Keimkristall und/oder Kristallisationskeim vorzugsweise ein AIN-Einkristall bereitgestellt. Alternativ kann der Keimkristall und/oder Kristallisationskeim aus einem anderen Material als das Quellenmaterial bestehen. Bei der Verwendung von AIN als Quellenmaterial kann beispielsweise als Keimkristall und/oder Kristallisationskeim alternativ ein SiC-Einkristall bereitgestellt werden.

Das gaspermeable Trennelement kann insbesondere als eine Platte, als eine Membran oder als ein Gitter ausgestaltet sein.

Das Verfahren umfasst die folgenden Schritte:
- Aufheizen des Quellenmaterials und des Einkristalls, so dass sich ein Temperaturgradient zwischen dem Quellenmaterial und dem Einkristall ausbildet. Hierbei bildet sich vorzugsweise ein in axialer Richtung verlaufender oder ein im Wesentlichen in axialer Richtung verlaufender Temperaturgradient aus. Das Quellenmaterial wird vorzugsweise auf Temperaturen von 1750°C bis 2500°C, besonders bevorzugt von 1900°C bis 2300°C, aufgeheizt.
- Verdampfen von heißem Quellenmaterial zur Bildung von gasförmigen Vorläufermaterial in der Gasphase. Das Quellenmaterial wird hierbei vorzugsweise sublimiert. Das gasförmige Vorläufermaterial wird sodann vorzugsweise in der Gasphase transportiert. Im Beispiel von SiC als Quellenmaterial umfasst das gasförmige Vorläufermaterial im Wesentlichen vorzugsweise gasförmiges SiC₂, gasförmiges Si und gasförmiges Si₂C.
- Abscheiden des gasförmigen Vorläufermaterials aus der Gasphase am Einkristall. Der Einkristall wird also vorzugsweise durch Anlagern des gasförmigen Vorläufermaterials vergrößert. Der ursprünglich vorgesehene Keimkristall und/oder Kristallisationskeim wird dadurch vorzugsweise immer weiter überwachsen. Der Einkristall wächst dabei insbesondere in axialer Richtung. Bei der Verwendung von SiC als Quellenmaterial wird SiC am Einkristall angelagert. Bei der Verwendung von AIN als Quellenmaterial wird AIN am Einkristall angelagert.

Das Quellenmaterial verdampft dabei in Abhängigkeit der Temperaturgradienten, insbesondere in Abhängigkeit von axialen und/oder radialen Temperaturgradienten. Alternativ oder zusätzlich kann das gasförmige Vorläufermaterial in Abhängigkeit der Temperaturgradienten, insbesondere in Abhängigkeit von axialen und/oder radialen Temperaturgradienten, transportiert und/oder abgeschieden werden.

Es hat sich gezeigt, dass die Wachstumsgeschwindigkeit und die Wachstumskinetik des Einkristalls, das heißt beispielsweise auch das Auftreten von Kristallbaufehlern, insbesondere von der Temperatur an der Oberfläche des Einkristalls abhängig ist. In Bereichen der Oberfläche des Einkristalls mit einer zu hohen Temperatur findet keine Anlagerung des gasförmigen Vorläufermaterials an den Einkristall statt. Bei einer zu niedrigen Temperatur findet eine zu schnelle Anlagerung des gasförmigen Vorläufermaterials statt, in deren Folge vermehrt Wachstumsfehler auftreten können. Mit Hilfe der Erfindung kann vorteilhafterweise die Temperatur an der dem gaspermeablen Trennelement zugewandten Wachstumsgrenzfläche des Einkristalls in Abhängigkeit der Temperaturgradienten eingestellt werden. Diese Temperatur wird vorzugsweise auf einen Bereich von 1750°C bis 2500 °C, besonders bevorzugt auf einen Bereich von 1900°C bis 2300°C, eingestellt. Die Temperaturgradienten haben vorzugsweise einen Betrag von 0,1 K/cm bis 10 K/cm. Der Durchmesser des Einkristalls beträgt vorzugsweise 100 mm bis 300 mm, besonders bevorzugt 150 mm, 200 mm, 250 mm oder 300 mm. Der Durchmesser des Wachstumstiegels übertrifft den Durchmesser des Einkristalls vorzugsweise um 1 mm bis 150 mm.

Die Temperaturgradienten können durch das Vorsehen des gaspermeablen Trennelements eingestellt werden. Das Vorsehen des gaspermeablen Trennelements kann die Wärmeleitung und die Konvektion innerhalb des Wachstumstiegels beeinflussen. Die Wärmeleitung erfolgt dabei grundsätzlich durch alle Feststoffe, Flüssigkeiten und Gase. Sie kann durch das Fourier-Gesetz beschrieben werden. Die Konvektion wird durch sich bewegende Gase und Flüssigkeiten verursacht. Das gaspermeable Trennelement beeinflusst die Temperaturgradienten und damit das Wachstum, das heißt insbesondere die Wachstumsgeschwindigkeit und/oder die Wachstumskinetik, des Einkristalls insbesondere mittels Wärmestrahlung, die insbesondere von der Oberfläche des gaspermeablen Trennelements ausgeht. Die Wärmeübertragung durch Strahlung wird bei der Kristallzüchtung typischerweise bei T > 500 °C signifikant und dominiert bei T > 1000 °C.

Die Temperaturgradienten, insbesondere die axialen und/oder radialen Temperaturgradienten werden durch die Ausgestaltung der ersten und/oder zweiten Oberfläche des gaspermeablen Trennelements und/oder durch eine Änderung der Position des gaspermeablen Trennelements eingestellt. Die Position des gaspermeablen Trennelements kann durch eine weiter unten beschriebene Stelleinrichtung eingestellt werden.

Durch die Einstellung der Temperaturgradienten kann insbesondere die Temperatur an der dem gaspermeablen Trennelement zugewandten Wachstumsgrenzfläche des Einkristalls eingestellt werden.

Die Temperatur des gaspermeablen Trennelements wird durch die weiter unten beschriebene Heizvorrichtung sowie durch einen Wärmeabtransport verursachende Wärmesenken bestimmt. Die Temperatur des gaspermeablen Trennelements kann als Mittelwert der Oberflächentemperaturen des Quellenmaterials und des wachsenden Einkristalls abgeschätzt werden. Die reine Anwesenheit des gaspermeablen Trennelements ohne Vorsehen einer Oberflächenmodifikation im Wachstumstiegel bringt die Funktion einer lokalen, passiven Heizung oder Kühlung. Durch Vorsehen einer Oberflächenmodifikation des gaspermeablen Trennelements können die Wärmeströme definiert in Größe und Richtung gesteuert werden.

Die Ausgestaltung der Oberfläche und/oder die Position des gaspermeablen Trennelements haben dabei insbesondere eine direkte Auswirkung auf die vom gaspermeablen Trennelement ausgehende Wärmestrahlung. Die vom gaspermeablen Trennelement ausgehende Wärmestrahlung kann vorzugsweise im Hinblick auf ihren Betrag und ihre Richtung lokal gesteuert werden. In Abhängigkeit der vom gaspermeablen Trennelement ausgehenden Wärmestrahlung können die Wärmeströme im Inneren des Wachstumstiegels gesteuert werden. Dabei wird vorzugsweise zusätzlich der Einfluss (i) einer weiter unten beschriebenen Heizvorrichtung zum Aufheizen des Quellenmaterials und/oder des Einkristalls, insbesondere eine geometrische Anordnung von Heizzonen, das Vorsehen einer induktiven Heizeinheit und/oder einer Widerstandsheizeinheit, (ii) des Aufbaus des Wachstumstiegels, (iii) einer den Wachstumstiegel umgebenden Wärmeisolation und/oder (iv) von die Wärmeisolation umgebenden Außenwände berücksichtigt. Durch das Steuern der Wärmeströme können die Temperaturgradienten eingestellt werden. Dabei können die Wärmeströme beispielsweise möglichst gleichmäßig im Inneren des Wachstumstiegels verteilt werden. In diesem Fall werden die Temperaturgradienten, insbesondere die radialen Temperaturgradienten, reduziert. Vorzugsweise sind möglichst geringe radiale Temperaturgradienten angestrebt, um Wachstumsfehler, z.B. Versetzungen beim Wachstum des Einkristalls, zu vermeiden. Alternativ dazu können die Wärmeströme in einem bestimmten Bereich oder in bestimmten Bereichen im Inneren des Wachstumstiegels konzentriert werden. Dadurch werden die von diesem Bereich oder von diesen Bereichen ausgehenden Temperaturgradienten erhöht.

Anders ausgedrückt besteht die Erfindung darin, durch Vorsehen des gaspermeablen Trennelements ein Pendant zu einer optischen Linse und/oder zu einem optischen Linsensystem zur Steuerung von Wärmeströmen und/oder Materialströmen in einem Wachstumstiegel zu schaffen. Der vom Quellenmaterial zum gaspermeablen Trennelement gelangende Wärmestrom und/oder Materialstrom kann als ein breiter Strahl aufgefasst werden. Der Wärmestrom und/oder Materialstrom kann durch das gaspermeable Trennelement in bestimmte räumliche Abschnitte verstärkt und in bestimmte andere räumliche Abschnitte abgeschwächt werden. Ein (weiter unten beschriebenes) im Emissionsgrad der ersten und/oder zweiten Oberfläche bearbeitetes gaspermeables Trennelement kann als Linse oder Linsensystem verstanden werden. Ein (weiter unten beschriebenes) mit einem ersten und/oder zweiten Relief versehenes gaspermeables Trennelement kann als Fresnellinse verstanden werden.

Mit Hilfe der Erfindung ist es vorteilhafterweise möglich, das Sublimationsverhalten des Quellenmaterials sowie die Wachstumsgeschwindigkeit und die Wachstumskinetik des Einkristalls definiert einzustellen. Dadurch können Wachstumsfehler, wie z.B. Versetzungen, vermieden werden. Daher eignet sich das erfindungsgemäße Verfahren insbesondere für die Herstellung großer Einkristalle, beispielsweise Einkristalle mit einem Durchmesser von 150 mm, 200 m, 250 mm, 300 mm oder mit einem noch größeren Durchmesser, insbesondere aus SiC oder AIN. Insbesondere können durch das erfindungsgemäße Verfahren optimale Wärmeströme im Inneren des Wachstumstiegels gezielt eingestellt werden. Dadurch kann ein optimales Temperaturfeld und eine geeignete Gasphasenzusammensetzung für den Stofftransport bzw. den Materialstrom erzielt werden.

Die vorliegende Erfindung ist nicht auf das PVT-Verfahren beschränkt, sondern kann bei allen Gasphasenwachstumsprozessen zum Einsatz kommen. Die vorliegende Erfindung kann beispielsweise bei Prozessen zum Einsatz kommen, bei denen Gase als Präkursoren zugeführt werden. Die vorliegende Erfindung kann also z. B. bei der chemischen Gasphasenabscheidung (CVD) zum Einsatz kommen.

Nach einer vorteilhaften Ausgestaltung der Erfindung weist die erste Oberfläche des gaspermeablen Trennelements einen vorbestimmten ersten Emissionsgrad und/oder die zweite Oberfläche des gaspermeablen Trennelements einen vorbestimmten zweiten Emissionsgrad auf. Der erste Emissionsgrad ist vorzugsweise auf einen Bereich von zwischen 0,01 und 0,5, besonders bevorzugt auf einen Bereich zwischen 0,2 und 0,4, oder auf einen Bereich zwischen 0,6 und 1,0, besonders bevorzugt auf einen Bereich zwischen 0,7 und 0,9, eingestellt. Der zweite Emissionsgrad ist vorzugsweise auf einen Bereich von zwischen 0,01 und 0,5, besonders bevorzugt auf einen Bereich zwischen 0,2 und 0,4, oder auf einen Bereich zwischen 0,6 und 1,0, besonders bevorzugt auf einen Bereich zwischen 0,7 und 0,9, eingestellt.

Der Emissionsgrad bestimmt vorzugsweise im Wesentlichen die vom gaspermeablen Trennelement ausgehende Wärmestrahlung. Der Emissionsgrad einer realen Oberfläche liegt zwischen 0 und 1. Ein idealer schwarzer Strahler weist einen Emissionsgrad von 1 auf. Eine ideal glänzende Oberfläche, das heißt ein perfekter Spiegel weist einen Emissionsgrad von 0 auf. Nachfolgend werden beispielshaft Emissionsgrade von für das gaspermeable Trennelement möglichen Materialien genannt: Schwarz-matter Graphit weist einen Emissionsgrad von 0,9 auf. Glänzender Graphit weist einen Emissionsgrad von 0,6 auf. Pyrolytisch mit Kohlenstoff (PyC) beschichteter Graphit weist einen Emissionsgrad im Bereich von 0,7 bis 0,9 auf. Glänzendes Ta oder TaC weist einen Emissionsgrad im Bereich von 0,1 bis 0,5 auf.

Durch die gezielte Einstellung des Emissionsgrads der Oberfläche gaspermeablen Trennelements können die Wärmestrahlung und damit die Wärmeströme definiert in eine oder mehrere Raumrichtungen gelenkt werden. Die Einstellung des Emissionsgrads kann beispielsweise durch mechanisches Polieren von mattschwarzem Graphit vorgenommen werden. Dabei kann der Emissionsgrad ausgehend von 0,9 bis auf 0,6 verringert werden. Ein weiteres Beispiel zur Einstellung des Emissionsgrads bringt das mechanische Aufrauen von glänzendem Graphit. Dabei kann der Emissionsgrad ausgehend von 0,6 bis auf 0,9 erhöht werden. Durch Beschichten und Ausheizen mit Kohlenstofflacken kann der Emissionsgrad in einem Bereich von 0,5 bis 0,99 eingestellt werden. Durch Beschichten mit Ta und/oder TaC kann der Emissionsgrad in einem Bereich von 0,1 bis 0,5 eingestellt werden.

Nach Maßgabe der Erfindung weist die erste Oberfläche des gaspermeablen Trennelements eine vorbestimmte Verteilung verschiedener Emissionsgrade und/oder die zweite Oberfläche des gaspermeablen Trennelements eine vorbestimmte Verteilung verschiedener Emissionsgrade auf.

Das Vorsehen einer Verteilung verschiedener Emissionsgrade kann durch bereichsweises Bearbeiten und/oder Beschichten der Oberfläche, das heißt der ersten und/oder zweiten Oberfläche, des gaspermeablen Trennelements erreicht werden. Das gaspermeable Trennelement kann dabei einheitlich aus einem Material gebildet sein, dessen Oberfläche durch das Bearbeiten und/oder Beschichten bereichsweise mit verschiedenen Emissionsgraden vorsehen wird. Dadurch können beispielsweise bereichsweise verschiedene Emissionsgrade zwischen 0,6 und 0,9 vorgesehen werden. Dies kann beispielsweise durch bereichsweises mechanisches Polieren von mattschwarzem Graphit erreicht werden. In den bearbeiteten Bereichen kann der Emissionsgrad ausgehend von 0,9 bis auf 0,6 verringert werden. Ein weiteres Beispiel bringt das bereichsweise mechanische Aufrauen von glänzendem Graphit. In den bearbeiteten Bereichen kann der Emissionsgrad ausgehend von 0,6 bis auf 0,9 erhöht werden. Weiterhin kann eine Verteilung verschiedener Emissionsgrade durch bereichsweises Beschichten und Ausheizen mit Kohlenstofflacken vorgesehen werden. Der Emissionsgrad lässt sich dadurch zwischen 0,5 und 0,99 einstellen. Durch bereichsweises Beschichten mit Ta und/oder TaC kann eine Verteilung verschiedener Emissionsgrade zwischen 0,1 und 0,5 vorgesehen werden.

Die vorbestimmte Verteilung verschiedener Emissionsgrade an der ersten Oberfläche des gaspermeablen Trennelements und/oder die vorbestimmte Verteilung verschiedener Emissionsgrade an der zweiten Oberfläche des gaspermeablen Trennelements weist vorzugsweise sich konzentrisch umgebende Abschnitte von unterschiedlichem Emissionsgrad auf.

Die Verteilung verschiedener Emissionsgrade an der ersten und/oder zweiten Oberfläche ist dabei also vorzugsweise radialsymmetrisch.

Vorzugsweise ist die Verteilung verschiedener Emissionsgrade an der ersten und/oder zweiten Oberfläche derart vorbestimmt, dass in radialer Erstreckung des gaspermeablen Trennelements innen ein kleinerer Emissionsgrad resultiert als außen.

Derart an der ersten Oberfläche resultierende Emissionsgrade führen vorteilhafterweise zu einer lokalen Erhöhung des axialen Temperaturgradienten vor der Wachstumsgrenzfläche im radial inneren Bereich im Vergleich zum radial äußeren Bereich des Wachstumstiegels. Dadurch reduziert sich vorteilhafterweise der radiale Temperaturgradient. Die Reduktion des radialen Temperaturgradienten führt vorteilhafterweise zu einem verbesserten Kristallwachstumsprozess. Die Reduktion des radialen Temperaturgradienten bewirkt insbesondere vorteilhafterweise ein gleichmäßigeres Wachstum und eine flachere Wachstumsgrenzfläche.

Nach einer weiteren vorteilhaften Ausgestaltung der Erfindung weist die erste Oberfläche des gaspermeablen Trennelements ein vorbestimmtes erstes Relief und/oder die zweite Oberfläche des gaspermeablen Trennelements ein vorbestimmtes zweites Relief auf. Das vorbestimmte erste Relief kann eine vorbestimmte erste Reliefstruktur sein. Das vorbestimmte zweite Relief kann eine vorbestimmte zweite Reliefstruktur sein.

Das Relief, das heißt das erste und/oder das zweite Relief, kann gekrümmte und/oder zueinander verkippte Flächen aufweisen. Die Flächen können konzentrisch angeordnet sein. Das Relief kann vorzugsweise einen Sägezahnverlauf aufweisen. Besonders bevorzugt kann das erste Relief einen Sägezahnverlauf mit nach außen gekippten konzentrisch angeordneten Flächen aufweisen und/oder das zweite Relief einen Sägezahnverlauf mit nach innen gekippten konzentrisch angeordneten Flächen aufweisen.

Das Relief kann beispielsweise eine sinusförmige, dreieckige, rechteckige oder trapezförmige Kontur haben. Durch Vorsehen eines Reliefs wird die effektive Oberfläche des gaspermeablen Trennelements vergrößert. Dadurch erhöht sich vorteilhafterweise die Menge der abgestrahlten Wärme. Weiterhin kann anhand der Winkel der gekrümmten und/oder verkippten Flächen die Richtung der Wärmestrahlung eingestellt werden. Dadurch können die Temperaturgradienten, insbesondere die axialen und/oder radialen Temperaturgradienten eingestellt werden. Beispielsweise können die Flächen des ersten Reliefs nach außen gekippt sein, wodurch die Wärmeströme in den radial außenliegenden Randbereich des Einkristalls verstärkt werden. In einem weiteren Beispiel können die Flächen des ersten Reliefs nach innen gekippt sein, wodurch die Wärmeströme in das radial innenliegende Zentrum des Einkristalls verstärkt werden. Vorteilhafterweise kann also durch Vorsehen eines Reliefs, das heißt eines ersten und/oder zweiten Reliefs, die Wachstumsgeschwindigkeit und Wachstumskinetik beeinflusst werden.

Das Vorsehen eines Reliefs kann insbesondere mit dem Vorsehen eines vorbestimmten Emissionsgrads oder einer vorbestimmten Verteilung verschiedener Emissionsgrade kombiniert werden. Eine solche Kombination kann an der ersten Oberfläche, an der zweiten Oberfläche oder an beiden Oberflächen des gaspermeablen Trennelements vorgesehen werden. Durch eine solche Kombination ist es noch genauer möglich, sowohl den radialen Temperaturgradienten beim wachsenden Einkristall und damit die thermisch induzierte Spannung im wachsenden Einkristall zu reduzieren, als auch die Temperatur und damit das Ab-Sublimieren des Quellenmaterials zu homogenisieren. Beides trägt zu einer Verbesserung der Wachstumsbedingungen des Einkristalls bei und ist insbesondere bei der Herstellung von Einkristallen, insbesondere aus SiC oder AIN, mit großen Durchmessern von 150 mm, 200 mm, 250 mm, 300 mm oder noch größer von großem Nutzen.

Nach einer weiteren vorteilhaften Ausgestaltung der Erfindung weisen die erste Oberfläche und die zweite Oberfläche des gaspermeablen Trennelements den gleichen vorbestimmten Emissionsgrad oder sich unterscheidende vorbestimmte Emissionsgrade auf. Im Fall des gleichen vorbestimmten Emissionsgrads ist also der erste gleich dem zweiten Emissionsgrad. Alternativ oder ergänzend weisen die erste Oberfläche und die zweite Oberfläche des gaspermeablen Trennelements die gleiche vorbestimmte Verteilung verschiedener Emissionsgrade oder sich unterscheidende vorbestimmte Verteilungen verschiedener Emissionsgrade auf. Alternativ oder ergänzend weisen die erste Oberfläche und die zweite Oberfläche des gaspermeablen Trennelements das gleiche vorbestimmte Relief oder sich unterscheidende vorbestimmte Reliefs auf.

Nach Maßgabe der Erfindung ist die Verteilung verschiedener Emissionsgrade an der ersten und/oder zweiten Oberfläche derart vorbestimmt, dass in einem radial innenliegenden Abschnitt ein kleinerer Emissionsgrad vorgesehen ist als in einem den radial innenliegenden Abschnitt konzentrisch umgebenden radial außenliegenden Abschnitt. Der radial außenliegende Abschnitt kann den radial innenliegenden Abschnitt unmittelbar umgeben. Alternativ können auch ein weiterer oder mehrere weitere konzentrische Abschnitte mit verschiedenen ersten Emissionsgraden zwischen dem radial innenliegenden Abschnitt und dem radial außenliegenden Abschnitt vorgesehen sein. Im radial innenliegenden Abschnitt ist vorzugsweise ein Emissionsgrad in einem Bereich zwischen 0,01 und 0,5, besonders bevorzugt in einem Bereich zwischen 0,2 und 0,4, und im radial außenliegenden Abschnitt ist vorzugsweise ein Emissionsgrad in einem Bereich zwischen 0,6 und 1,0, besonders bevorzugt in einem Bereich zwischen 0,7 und 0,9, vorgesehen.

Durch das Vorsehen von konzentrischen Abschnitten von unterschiedlichem Emissionsgrad auf der ersten Oberfläche kann die vom gaspermeablen Trennelement in Richtung Einkristall ausgehende Wärmestrahlung beispielsweise in das radial außenliegende Randgebiet des Einkristalls oder in das radial innenliegende Zentrum des Einkristalls ausgerichtet werden. Entsprechend können die Wärmeströme zum radial außenliegenden Randgebiet des Einkristalls oder zum radial innenliegenden Zentrum des Einkristalls verstärkt werden. Dadurch kann einerseits Einfluss genommen werden auf den Verlauf der Isothermen und auf die radialen Temperaturgradienten im Gasraum. Andererseits kann dadurch Einfluss genommen werden auf die Übersättigung der wachstumsrelevanten Spezies, insbesondere in der unmittelbaren Umgebung des wachsenden Einkristalls. Diese Übersättigung resultiert aus einer Erhöhung des Partialdrucks des gasförmigen Vorläufermaterials, insbesondere der wachstumsrelevanten Spezies. Bei der Sublimationskristallisation von SiC kann beispielsweise der Partialdruck der wachstumsrelevanten Spezies SiC₂ erhöht werden. Dadurch kann die das Kristallwachstum begünstigende chemische Reaktion SiC₂(Gas) + Si (Gas) → SiC (fest) verstärkt werden. Ein definiertes Einstellen der Übersättigung ist insbesondere bei der Herstellung von Einkristallen aus SiC vorteilhaft. In Abhängigkeit des gewünschten Polytyps kann eine unterschiedliche Stärke der Übersättigung vorteilhaft sein. Kubisches SiC, das heißt 3C-SiC, ist besonders stabil bei einer starken Übersättigung. Bei hexagonalem SiC ist eine geringere Übersättigung vorteilhaft.

Durch Vorsehen von konzentrischen Abschnitten von unterschiedlichem Emissionsgrad kann also vorteilhafterweise das Wachstum des Einkristalls verbessert werden.

Nach einer weiteren vorteilhaften Ausgestaltung der Erfindung sind weitere konzentrische Abschnitte mit sich in radial nach außen gerichteter Richtung kontinuierlich oder diskret erhöhenden Emissionsgraden zwischen dem radial innenliegenden Abschnitt und dem radial außenliegenden Abschnitt vorgesehen.

Nach einer weiteren vorteilhaften Ausgestaltung der Erfindung ist die Verteilung verschiedener Emissionsgrade an der ersten und/oder zweiten Oberfläche derart vorbestimmt, dass in Radialrichtung zueinander konzentrische Bereiche unterschiedlicher Breite abwechselnd jeweils mit einem niedrigen und einem hohen Emissionsgrad vorgesehen sind. Dabei resultiert jeweils aus dem Verhältnis der Breite des Bereichs mit niedrigem Emissionsgrad und der Breite des diesen unmittelbar umgebenden Bereichs mit hohem Emissionsgrad ein effektiver Emissionsgrad. Der effektive Emissionsgrad erhöht sich von innen nach außen. Der effektive Emissionsgrad kann dabei also quasikontinuierlich eingestellt sein. Vorzugsweise ist der hohe Emissionsgrad 0,8 und der niedrige Emissionsgrad ist vorzugsweise 0,1.

Nach Maßgabe der Erfindung ist weiterhin ein Wachstumstiegel zur Herstellung und/oder Vergrößerung eines Einkristalls, insbesondere durch ein erfindungsgemäßes Verfahren, vorgesehen.

Der Wachstumstiegel ist zylindrisch. Der Wachstumstiegel kann dabei im Querschnitt elliptisch oder vorzugsweise kreisrund sein. Das Verhältnis des Durchmessers zur Länge des Wachstumstiegels beträgt vorzugsweise 2:1 bis 1:10, besonders bevorzugt 1:2 bis 1:6. Der Wachstumstiegel weist eine Tiegelwand auf. Die Tiegelwand weist vorzugsweise einen Innendurchmesser im Bereich von 100 mm bis 450 mm auf, besonders bevorzugt im Bereich von 150 mm bis 350 mm. Der Wachstumstiegel umfasst in seinem Inneren ein Quellenmaterial, den Einkristall und ein zwischen dem Quellenmaterial und dem Einkristall vorgesehenes gaspermeables Trennelement mit einer dem Einkristall zugewandten ersten Oberfläche und einer dem Quellenmaterial zugewandten zweiten Oberfläche. Das Innere des Wachstumstiegels weist vorzugsweise eine zylindrische Form oder eine im Wesentlichen zylindrische Form auf. Vorzugsweise sind das Quellenmaterial und der Einkristall an den beiden axial gegenüberliegenden Enden des Inneren des Wachstumstiegels angeordnet.

Der Wachstumstiegel ist zur Steuerung von Temperaturgradienten ausgebildet. Ein Temperaturgradient, der vorzugsweise in axialer Richtung verläuft, ist zwischen dem Quellenmaterial und dem Einkristall durch Aufheizen des Quellenmaterials und des Einkristalls ausbildbar. Gasförmiges Vorläufermaterial ist in der Gasphase durch Verdampfen von heißem Quellenmaterial bildbar. Das gasförmiges Vorläufermaterial wird weiterhin in der Gasphase transportiert und ist aus der Gasphase am Einkristall abscheidbar. Dabei erfolgt das Verdampfen und/oder der Transport und/oder das Abscheiden des gasförmigen Vorläufermaterials in Abhängigkeit der Temperaturgradienten. Vorzugsweise folgt der Stofftransport bzw. der Materialstrom im Wesentlichen den senkrecht zu den Isothermen verlaufenden Temperaturgradienten.

Die Temperaturgradienten sind durch die Ausgestaltung der ersten und/oder zweiten Oberfläche des gaspermeablen Trennelements und/oder durch eine Änderung der Position des gaspermeablen Trennelements einstellbar.

Nach einer vorteilhaften Ausgestaltung der Erfindung weist der Wachstumstiegel eine Stelleinrichtung zur Einstellung der Position des gaspermeablen Trennelements auf. Mit Hilfe der Stelleinrichtung kann eine Nachführung des gaspermeablen Trennelements vorgesehen werden. Dadurch können die Wachstumsbedingungen im Gasraum während des Wachstumsprozesses konstant gehalten werden. So kann beispielsweise der Abstand zwischen dem gaspermeablen Trennelement und dem wachsenden Einkristall, insbesondere der Abstand zu einer dem gaspermeablen Trennelement zugewandten und vorzugsweise konvexen Grenzfläche des Einkristalls, konstant gehalten werden. Weiterhin kann der Abstand zwischen dem gaspermeablen Trennelement und dem Quellenmaterial konstant gehalten werden. Darüber hinaus kann der Verbrauch des Quellenmaterials durch ein Absenken des gaspermeablen Trennelements lokal gesteuert werden. Insbesondere kann das Verdampfen des Quellenmaterials verstärkt werden.

Die Stelleinrichtung ist vorzugsweise aus Graphit oder TaC gebildet. Die Stelleinrichtung kann durch ein Rohr geführt werden. Das Rohr kann insbesondere zentral axial durch das Quellenmaterial verlaufen. In diesem Fall kann die Stelleinrichtung durch eine axial verlaufende Manipulatorstange gebildet sein. Durch einen freien im Rohr vorgesehenen Raum kann Inertgas in das Innere des Wachstumstiegels eingeleitet werden. Das Einleiten des Inertgases verhindert vorteilhafterweise ein Ausströmen des gasförmigen Vorläufermaterials in den freien Raum. Dadurch kann der Wachstumstiegel also abgedichtet werden. Das Rohr kann auch bereits ohnehin für die Gasversorgung vorhanden sein. Die Manipulatorstange ist vorzugsweise mit dem gaspermeablen Trennelement verbunden. Die Manipulatorstange trifft dazu vorzugsweise zentral auf die zweite Oberfläche des gaspermeablen Trennelements und ist dort mit dem gaspermeablen Trennelement verbunden.

Alternativ dazu kann die Stelleinrichtung beispielsweise auch als ein Manipulatorzylinder ausgebildet sein. Der Manipulatorzylinder ist vorzugsweise ein das Quellenmaterial radial umgebender Hohlzylinder. In diesem Fall bildet das gaspermeablen Trennelement vorzugsweise eine Stirnfläche des als Hohlzylinder ausgestalteten Manipulatorzylinders. Der äußere Umfang des gaspermeablen Trennelement ist in diesem Fall also mit einem Ende des als Hohlzylinder ausgestalteten Manipulatorzylinders verbunden. Zwischen dem Manipulatorzylinder und der Innenseite der Tiegelwand kann ein freier Raum vorgesehen sein. Durch den freien Raum kann Inertgas in das Innere des Wachstumstiegels eingeleitet werden. Das Einleiten des Inertgases verhindert vorteilhafterweise ein Ausströmen des gasförmigen Vorläufermaterials in den freien Raum. Dadurch kann der Wachstumstiegel also abgedichtet werden.

Die Manipulatorstange und/oder der Manipulatorzylinder sind vorzugsweise aus Graphit oder TaC gebildet. Bei den beiden genannten Ausführungen der Stelleinrichtung ist das Quellenmaterial vorzugsweise als massiver Volumenkörper, insbesondere in Form eines dichten Zylinderblocks, vorgesehen.

Das Vorsehen einer Stelleinrichtung zur Einstellung der Position des gaspermeablen Trennelements kann insbesondere mit dem Vorsehen eines vorbestimmten Emissionsgrads oder einer vorbestimmten Verteilung verschiedener Emissionsgrade und/oder mit dem Vorsehen eines Reliefs kombiniert werden. Dadurch kann ein besonders stabiler Wachstumsprozess erreicht werden.

Nach einer weiteren vorteilhaften Ausgestaltung der Erfindung ist das gaspermeable Trennelement als eine Platte, als eine Membran oder als ein Gitter ausgestaltet.

Das gaspermeable Trennelement kann aus einem gezielt mit Öffnungen versehenen Vollmaterial oder aus einem porösen Schaum gebildet sein. Das gaspermeable Trennelement kann aus einem hochtemperaturstabilen, insbesondere bei Temperaturen höher als 2000°C stabilen, chemisch mit der Sublimationskristallisation kompatiblen Material gebildet sein.

Nach einer weiteren vorteilhaften Ausgestaltung der Erfindung ist das gaspermeable Trennelement aus einem Metallkarbid und/oder Metallkarbidschaum, insbesondere aus TaC und/oder TaC-Schaum gebildet. Das gaspermeable Trennelement kann z.B. als eine Platte aus TaC mit Löchern ausgestaltet sein. Darüber hinaus kann das gaspermeable Trennelement aus beschichtetem Graphit gebildet sein. Die Beschichtung kann dabei vorzugsweise TaC sein. Das gaspermeable Trennelement kann eine Graphitplatte sein. Die Graphitplatte kann aus einem gezielt mit Öffnungen versehenen Vollmaterial oder aus einem porösen Graphitschaum gebildet sein. Weiterhin kann das gaspermeable Trennelement aus SiC, beispielsweise aus einer SiC-Keramik oder aus einem SiC-Wafer, gebildet sein. Insbesondere kann das gaspermeable Trennelement eine SiC-Platte sein. Die SiC-Platte kann aus einkristallinem oder polykristallinem SiC gebildet sein. Weiterhin kann die SiC-Platte aus verdichtetem und/oder gesintertem Pulver gebildet sein. Im Falle einer Verwendung von AIN als Quellenmaterial kommen für das gaspermeable Trennelement vorzugsweise TaC oder Wolfram (jeweils als Platte mit Löchern oder als Schaum) zum Einsatz.

Nach einer weiteren vorteilhaften Ausgestaltung der Erfindung ist als Quellenmaterial SiC, vorzugsweise ein SiC-Pulver und/oder ein SiC-Volumenkörper, vorgesehen. Der SiC-Volumenkörper kann insbesondere polykristallin sein. Bei der Verwendung von SiC als Quellenmaterial wird als Einkristall ein SiC-Einkristall gebildet. Vorzugsweise wird dabei zur Durchführung des erfindungsgemäßen Verfahrens zunächst ein SiC-Einkristall als Keimkristall und/oder Kristallisationskeim am dem Quellenmaterial gegenüberliegenden Ende des Inneren des Wachstumstiegels vorgesehen. Während der Durchführung des erfindungsgemäßen Verfahrens wird der SiC-Einkristall vergrößert. Dabei wächst der SiC-Einkristall vorzugsweise in axialer Richtung.

Alternativ dazu kann als Quellenmaterial AIN vorgesehen sein. Vorzugsweise kann dabei ein AIN-Pulver und/oder ein AIN-Volumenkörper, insbesondere ein polykristalliner AIN-Volumenkörper, vorgesehen sein. Bei der Verwendung von AIN als Quellenmaterial wird als Einkristall ein AIN-Einkristall gebildet Vorzugsweise wird dabei zur Durchführung des erfindungsgemäßen Verfahrens zunächst ein AIN-Einkristall als Keimkristall und/oder Kristallisationskeim am dem Quellenmaterial gegenüberliegenden Ende des Inneren des Wachstumstiegels vorgesehen. Während der Durchführung des erfindungsgemäßen Verfahrens wird der AIN-Einkristall vergrößert. Dabei wächst der AIN-Einkristall vorzugsweise in axialer Richtung. Wie oben bereits beschrieben kann bei der Verwendung von AIN als Quellenmaterial als Keimkristall und/oder Kristallisationskeim alternativ beispielsweise ein SiC-Einkristall vorgesehen sein.

Nach einer weiteren vorteilhaften Ausgestaltung der Erfindung ist die Tiegelwand aus Graphit und/oder Ta und/oder TaC und/oder beschichtetem Graphit, insbesondere aus pyrolytisch mit Kohlenstoff beschichtetem Graphit und/oder aus mit Ta und/oder TaC beschichtetem Graphit, gebildet. Für eine pyrolytische Beschichtung mit Kohlenstoff kann auch die Kurzschreibweise PyC verwendet werden.

Vorzugsweise ist der Wachstumstiegel dazu geeignet auf Temperaturen im Bereich von 1000°C bis 2500°C, insbesondere Temperaturen im Bereich von 1500°C bis 2500°C aufgeheizt zu werden.

Nach einer weiteren vorteilhaften Ausgestaltung der Erfindung umfasst der Wachstumstiegel eine Heizvorrichtung zum Aufheizen des Quellenmaterials und/oder des Einkristalls. Die Heizvorrichtung umfasst vorzugsweise eine induktive Heizeinheit und/oder eine Widerstandsheizeinheit.

Weiterhin kann der Wachstumstiegel eine Wärmeisolierung aufweisen. Die Wärmeisolierung umgibt die Tiegelwand vorzugsweise vollständig oder im Wesentlichen vollständig.

Die induktive Heizeinheit wird vorzugsweise mit einer Spule gebildet. Die Spule kann außerhalb der Wärmeisolierung vorgesehen sein. Beim Vorsehen einer induktiven Heizeinheit ist vorzugsweise die Tiegelwand des Wachstumstiegel elektrisch leitfähig. Die induktive Heizeinheit ist vorzugsweise in einem Frequenzbereich zwischen 3 und 50 kHz, besonders bevorzugt zwischen 5 und 20 kHz, betreibbar.

Die Widerstandsheizeinheit ist vorzugsweise mit Graphitheizelementen ausgestaltet. Die Graphitheizelemente bilden vorzugsweise eine Heizwicklung außen um die Tiegelwand des Wachstumstiegel. Beim Vorsehen einer Widerstandsheizeinheit ist die Wärmeisolation vorzugsweise außen um die Widerstandsheizeinheit herum vorgesehen.

Die induktive Heizeinheit und die Widerstandsheizeinheit können miteinander kombiniert werden. Vorzugsweise kann also sowohl eine induktive Heizeinheit als auch eine Widerstandsheizeinheit vorgesehen sein. Dabei umgibt vorzugsweise die Widerstandsheizeinheit die Tiegelwand, die Wärmeisolation die Widerstandsheizeinheit und die induktive Heizeinheit die Wärmeisolation. Vorzugsweise umgibt dabei die Widerstandsheizeinheit unmittelbar die Tiegelwand, und/oder die Wärmeisolation unmittelbar die Widerstandsheizeinheit, und/oder die induktive Heizeinheit unmittelbar die Wärmeisolation.

Die Erfindung wird nun anhand von Ausführungsbeispielen näher erläutert. Es zeigen
- Fig. 1: eine schematische Darstellung eines Wachstumstiegels nach dem Stand der Technik,
- Fig. 2A: eine schematische Darstellung eines ersten erfindungsgemäßen Wachstumstiegels,
- Fig. 2B: eine schematische Darstellung eines zweiten erfindungsgemäßen Wachstumstiegels,
- Fig. 3A: eine schematische Darstellung eines dritten erfindungsgemäßen Wachstumstiegels,
- Fig. 3B: eine schematische Darstellung eines vierten erfindungsgemäßen Wachstumstiegels,
- Fig. 4: eine schematische Darstellung eines fünften erfindungsgemäßen Wachstumstiegels,
- Fig. 5: eine schematische Darstellung eines sechsten erfindungsgemäßen Wachstumstiegels,
- Fig. 6: eine schematische Darstellung eines siebten erfindungsgemäßen Wachstumstiegels,
- Fig. 7: eine schematische Darstellung eines achten erfindungsgemäßen Wachstumstiegels,
- Fig. 8: eine schematische Darstellung eines neunten erfindungsgemäßen Wachstumstiegels,
- Fig. 9: eine schematische Darstellung eines zehnten erfindungsgemäßen Wachstumstiegels,
- Fig. 10: eine schematische Darstellung eines elften erfindungsgemäßen Wachstumstiegels,
- Fig. 11: eine schematische Darstellung eines zwölften erfindungsgemäßen Wachstumstiegels,
- Fig. 12: eine schematische Darstellung eines dreizehnten erfindungsgemäßen Wachstumstiegels.

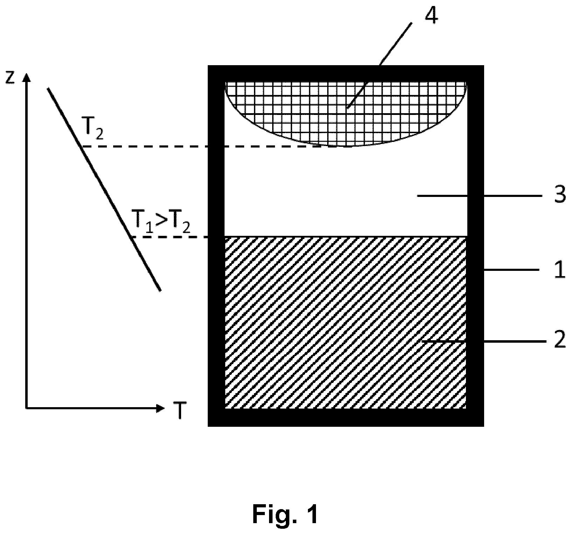

Fig. 1 zeigt eine schematische Darstellung eines Wachstumstiegels nach dem Stand der Technik. Der zylindrische Wachstumstiegel weist eine Tiegelwand 1 auf. Im Inneren des Wachstumstiegels sind ein Quellenmaterial 2, ein Gasraum 3 und ein Einkristall 4 aufgenommen. Das Quellenmaterial 2 und der Einkristall 4 sind an den beiden axial gegenüberliegenden Enden des Inneren des Wachstumstiegels angeordnet und dabei durch den Gasraum 3 voneinander getrennt. Das Quellenmaterial 2 hat eine im Wesentlichen zylindrische Form. Der Einkristall 4 hat die Form eines einseitig konvex abgerundeten Zylinders. Das Quellenmaterial 2 ist beispielsweise ein Pulver aus Siliziumkarbid (in Formelschreibweise SiC). Als Einkristall 4 wird entsprechend ein Einkristall aus SiC hergestellt.

Der Wachstumstiegel wird zur Vergrößerung des Einkristalls 4 so aufgeheizt, dass Quellenmaterial 2 durch Sublimation in die Gasphase übergeht, als gasförmiges Vorläufermaterial durch den Gasraum transportiert wird und am Einkristall 4 auskristallisiert.

Dem Wachstumstiegel ist schematisch der Verlauf der Temperatur T in z-Richtung, das heißt in Axialrichtung des Wachstumstiegels gegenübergestellt. Die Temperatur an der an den Gasraum 3 angrenzenden Grenzfläche des Quellenmaterials 2 beträgt T₁. Die Grenzfläche des Quellenmaterials 2 ist vorzugsweise eben oder im Wesentlichen eben. Vorzugsweise ist die Temperatur entlang der Grenzfläche des Quellenmaterials 2 konstant. Die Grenzfläche des Quellenmaterials 2 liegt also vorzugsweise auf einer Isothermen mit der Temperatur T₁. Die Temperatur T₁ ist ausreichend hoch eingestellt, dass es zu einer Sublimation von Quellenmaterial 2 kommt. Die Temperatur an der an den Gasraum 3 angrenzenden Grenzfläche des Einkristalls 4 beträgt T₂. Diese Grenzfläche des Einkristalls 4 hat eine konvexe Form und kann auch als Wachstumsgrenzfläche bezeichnet werden. Vorzugsweise ist die Temperatur entlang der konvexen Wachstumsgrenzfläche konstant. Die Wachstumsgrenzfläche ist also vorzugsweise entlang einer Isotherme mit der Temperatur T₂ ausgebildet. Die Temperatur T₂ ist kleiner als die Temperatur T₁. Zwischen dem Quellenmaterial 2 und dem Einkristall 4 ist also ein axialer Temperaturgradient ausgebildet. Die Temperatur T₂ ist so eingestellt, dass es zu einer Übersättigung des gasförmigen Vorläufermaterials, insbesondere zu einer Übersättigung der Wachstumsspezies, und dadurch zu einer Kristallisation am Einkristall 4 kommt. Das Quellenmaterial 2 wird durch die Sublimation fortwährend abgetragen. Der Einkristall 4 wird durch die Kristallisation fortwährend vergrößert. Vorzugsweise bildet sich die Wachstumsgrenzfläche dabei beständig entlang einer Isotherme.

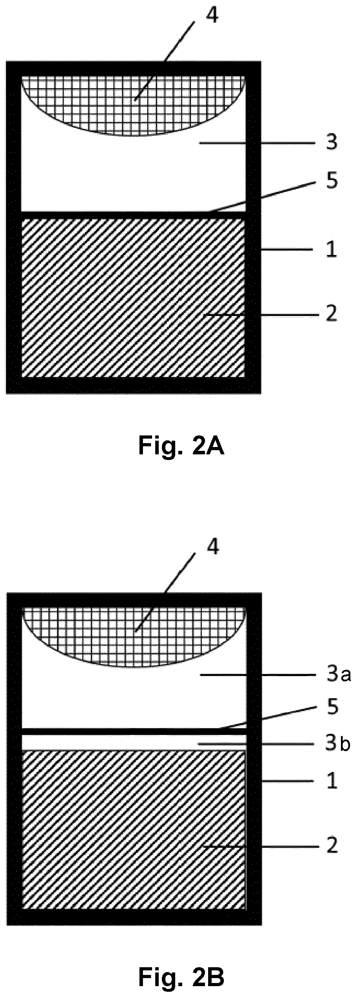

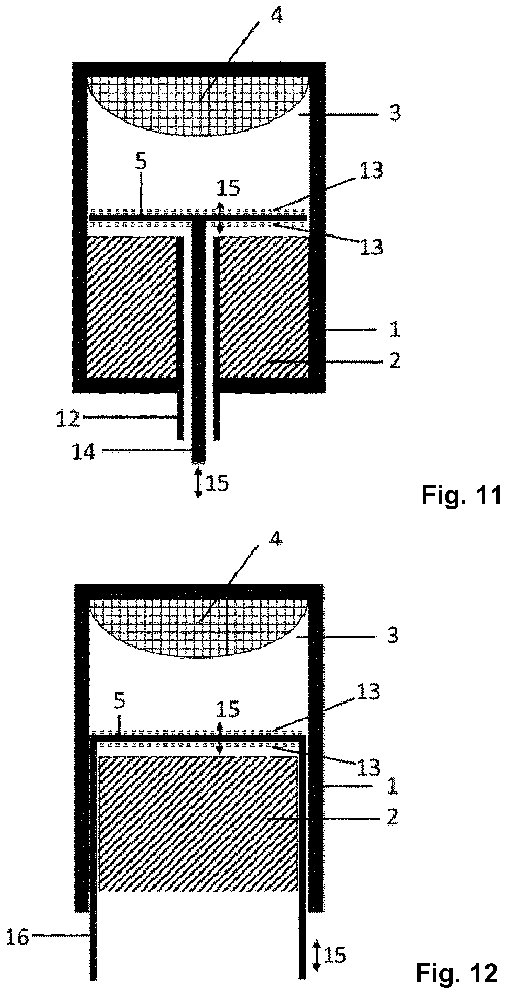

Die Figuren 2 bis 12 zeigen jeweils schematische Darstellungen eines ersten bis dreizehnten erfindungsgemäßen Wachstumstiegels. Der Wachstumstiegel weist in allen Ausführungsformen der Erfindung jeweils alle beschriebenen Elemente und Eigenschaften des Wachstumstiegels aus Fig. 1 auf. Zusätzlich weist der Wachstumstiegel jeweils ein gaspermeables Trennelement 5 auf. Das gaspermeable Trennelement 5 weist eine dem Einkristall 4 zugewandte erste Oberfläche und eine dem Quellenmaterial 2 zugewandte zweite Oberfläche auf. Die erste und/oder zweite Oberfläche des gaspermeablen Trennelements 5 ist so ausgestaltet, dass die vom gaspermeablen Trennelement 5 ausgehende Wärmestrahlung, der Verlauf sowie die Stärke der Wärmeströme und dadurch die Temperaturgradienten einstellbar sind. Wie exemplarisch in den Figuren 11 und 12 gezeigt ist, können die vom gaspermeablen Trennelement 5 ausgehende Wärmestrahlung, der Verlauf sowie die Stärke der Wärmeströme und die Temperaturgradienten alternativ dazu oder ergänzend durch eine Änderung der Position des gaspermeablen Trennelements 5 eingestellt werden.

Das gaspermeable Trennelement 5 ist aus einem hochtemperaturstabilen, chemisch mit der Sublimationskristallisation kompatiblen Material gebildet. Vorzugsweise ist das gaspermeable Trennelement aus Graphit gebildet, beispielsweise aus einer gelochten Platte aus Graphit oder aus GraphitSchaum. Alternativ dazu kann das gaspermeable Trennelement aus TaC gebildet sein, beispielsweise aus einer gelochten Platte aus TaC oder aus einem TaC-Schaum. Die Tiegelwand 1 ist vorzugsweise aus Graphit gebildet. Die Tiegelwand 1 kann alternativ dazu aus TaC gebildet sein. Weiterhin kann die Tiegelwand 1 aus Graphit gebildet sein und eine TaC-Beschichtung auf ihrer Innenseite aufweisen.

Beim ersten erfindungsgemäßen Wachstumstiegel gemäß Fig. 2A befindet sich der Gasraum 3 zwischen dem gaspermeablen Trennelement 5 und dem Einkristall 4. Das Quellenmaterial 2 reicht im Wesentlichen bis zur zweiten Oberfläche des gaspermeable Trennelements 5. Beim ersten erfindungsgemäßen Wachstumstiegel ist nur die erste Oberfläche des gaspermeablen Trennelements 5 so ausgestaltet, dass die vom gaspermeablen Trennelement 5 ausgehende Wärmestrahlung, der Verlauf sowie die Stärke der Wärmeströme und dadurch die Temperaturgradienten einstellbar sind.

Beim zweiten erfindungsgemäßen Wachstumstiegel gemäß Fig. 2B befindet sich ein erster Gasraum 3a zwischen dem gaspermeablen Trennelement 5 und dem Einkristall 4 und ein zweiter Gasraum 3b zwischen dem gaspermeablen Trennelement 5 und dem Quellenmaterial 2. Der Gasraum 3 wird hier also aus dem ersten Gasraum 3a und dem zweiten Gasraum 3b gebildet. Beim zweiten erfindungsgemäßen Wachstumstiegel sind vorzugsweise die erste und die zweite Oberfläche des gaspermeablen Trennelements 5 so ausgestaltet, dass die vom gaspermeablen Trennelement 5 ausgehende Wärmestrahlung, der Verlauf sowie die Stärke der Wärmeströme und dadurch die Temperaturgradienten einstellbar sind.

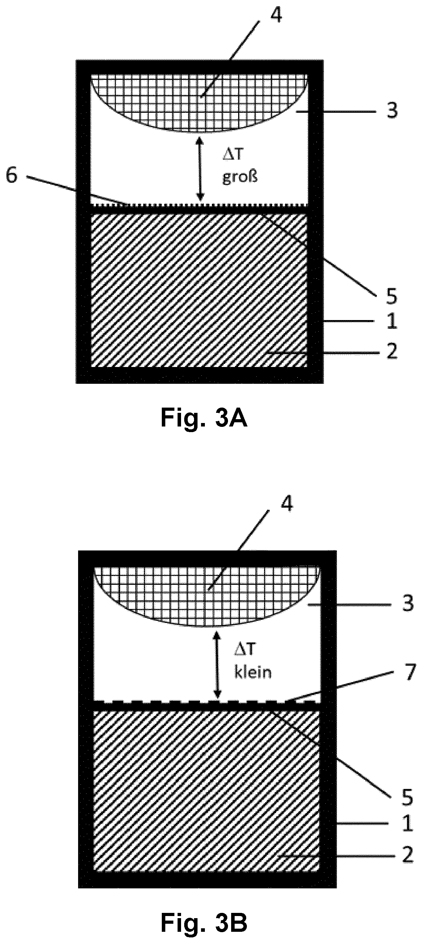

Beispiele für die Ausgestaltung der ersten und/oder zweiten Oberfläche des gaspermeablen Trennelements 5 sind in den Figuren 3A bis 10 gezeigt.

Beim dritten erfindungsgemäßen Wachstumstiegel gemäß Fig. 3A ist die erste Oberfläche des gaspermeablen Trennelements 5 exemplarisch so bearbeitet und/oder mit einer Beschichtung versehen und/oder das gaspermeable Trennelement 5 aus einem derartigen Material gebildet, dass die erste Oberfläche des gaspermeablen Trennelements 5 eine im Emissionsgrad ε reduzierte Oberfläche 6 ist. Der Wert des Emissionsgrads ε der im Emissionsgrad ε reduzierten Oberfläche 6 liegt in einem Bereich zwischen 0,01 und 0,5, vorzugsweise in einem Bereich zwischen 0,2 und 0,4, beispielsweise bei 0,25. Dies führt zu einer Erhöhung des axialen Temperaturgradienten. Die Differenz zwischen den Temperaturen T₁ und T₂ ist also vergrößert. Das in Fig. 3A schematisch gezeigte Muster von dünnen Erhebungen an der ersten Oberfläche ist rein illustrativer Natur und wird in den Figuren jeweils zur Kennzeichnung eines kleinen Emissionsgrads ε im Bereich zwischen 0,01 und 0,5 verwendet. Tatsächlich ist die beim dritten erfindungsgemäßen Wachstumstiegel in ihrem Emissionsgrad ε veränderte erste Oberfläche eben oder im Wesentlichen eben und weist die schematisch gezeigten dünnen Erhebungen nicht auf.

Beim vierten erfindungsgemäßen Wachstumstiegel gemäß Fig. 3B ist die erste Oberfläche des gaspermeablen Trennelements 5 exemplarisch so bearbeitet und/oder mit einer Beschichtung versehen und/oder das gaspermeable Trennelement 5 aus einem derartigen Material gebildet, dass die erste Oberfläche des gaspermeablen Trennelements 5 eine im Emissionsgrad ε erhöhte Oberfläche 7 ist. Der Wert des Emissionsgrads ε der im Emissionsgrad ε erhöhten Oberfläche 7 liegt in einem Bereich zwischen 0,6 und 1,0, vorzugsweise in einem Bereich zwischen 0,7 und 0,9, beispielsweise bei 0,85. Dies führt zu einer Reduzierung des axialen Temperaturgradienten. Die Differenz zwischen den Temperaturen T₁ und T₂ sinkt also. Das in Fig. 3B schematisch gezeigte Muster von breiten Erhebungen an der ersten Oberfläche ist rein illustrativer Natur und wird in den Figuren jeweils zur Kennzeichnung eines großen Emissionsgrads ε im Bereich zwischen 0,6 und 1,0 verwendet. Tatsächlich ist die beim vierten bis achten erfindungsgemäßen Wachstumstiegel in ihrem Emissionsgrad ε veränderte erste Oberfläche eben oder im Wesentlichen eben und weist die schematisch gezeigten breiten Erhebungen nicht auf.

Der Emissionsgrad ε der im Emissionsgrad ε reduzierten Oberfläche 6 und der Emissionsgrad ε der im Emissionsgrad ε erhöhten Oberfläche 7 liegt auch in den folgenden Beispielen jeweils bei den oben genannten Werten.

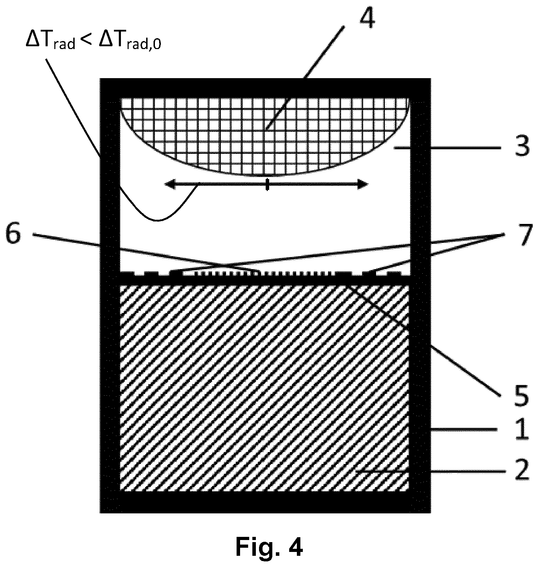

Beim fünften erfindungsgemäßen Wachstumstiegel gemäß Fig. 4 weist die erste Oberfläche des gaspermeablen Trennelements 5 einen radial innenliegenden und einen radial außenliegenden Abschnitt auf. Der radial innenliegende und der radial außenliegende Abschnitt sind zueinander konzentrisch angeordnet. Die erste Oberfläche des gaspermeablen Trennelements 5 ist derart bearbeitet und/oder beschichtet, dass der radial innenliegende Abschnitt eine im Emissionsgrad ε reduzierte Oberfläche 6 aufweist und der radial außenliegende Abschnitt eine im Emissionsgrad ε erhöhte Oberfläche 7 aufweist.

Das Vorsehen der im Emissionsgrad ε reduzierten Oberfläche 6 im radial innenliegenden Abschnitt und das Vorsehen der im Emissionsgrad ε erhöhten Oberfläche 7 im radial außenliegenden Abschnitt führt zu einer lokalen Erhöhung des axialen Temperaturgradienten vor der Wachstumsgrenzfläche im radial inneren Bereich im Vergleich zum radial äußeren Bereich des Wachstumstiegels. Dies führt zu einer Reduktion des radialen Temperaturgradienten ΔT_{rad} im Vergleich zu einem radialen Temperaturgradienten ΔT_{rad,0} ohne Bearbeitung und/oder Beschichtung der ersten Oberfläche. Die Reduktion des radialen Temperaturgradienten ΔT_{rad} führt vorteilhafterweise zu einem verbesserten Kristallwachstumsprozess. Die Reduktion des radialen Temperaturgradienten ΔT_{rad} bewirkt insbesondere vorteilhafterweise ein gleichmäßigeres Wachstum und eine flachere Wachstumsgrenzfläche.

Weiterhin können beim fünften erfindungsgemäßen Wachstumstiegel mehrere konzentrisch angeordnete Abschnitte mit von innen nach außen ansteigendem Emissionsgrad ε vorgesehen sein. Der Emissionsgrad ε kann dabei beispielsweise graduell ansteigen oder abrupt bei einem oder mehreren radial außenliegenden Abschnitten ansteigen.

Alternativ zum fünften erfindungsgemäßen Wachstumstiegel kann die Anordnung der im Emissionsgrad ε reduzierten Oberfläche 6 und der im Emissionsgrad ε erhöhten Oberfläche 7 durch Bearbeiten und/oder Beschichten der ersten Oberfläche auch invers vorgenommen werden (nicht gezeigt). Die im Emissionsgrad ε reduzierte Oberfläche 6 kann also im radial außenliegenden Abschnitt und die im Emissionsgrad ε erhöhte Oberfläche 7 kann im radial innenliegenden Abschnitt vorgesehen werden. Diese Maßnahme führt zu einer Erhöhung des radialen Temperaturgradienten ΔT_{rad}.

Auch bei der inversen Anordnung können mehrere konzentrisch angeordnete Abschnitte vorgesehen sein. Die mehreren konzentrisch angeordneten Abschnitte weisen in diesem Fall einen von innen nach außen sinkenden Emissionsgrad ε auf. Der Emissionsgrad ε kann dabei graduell sinken oder abrupt bei einem oder mehreren radial außenliegenden Abschnitten sinken.

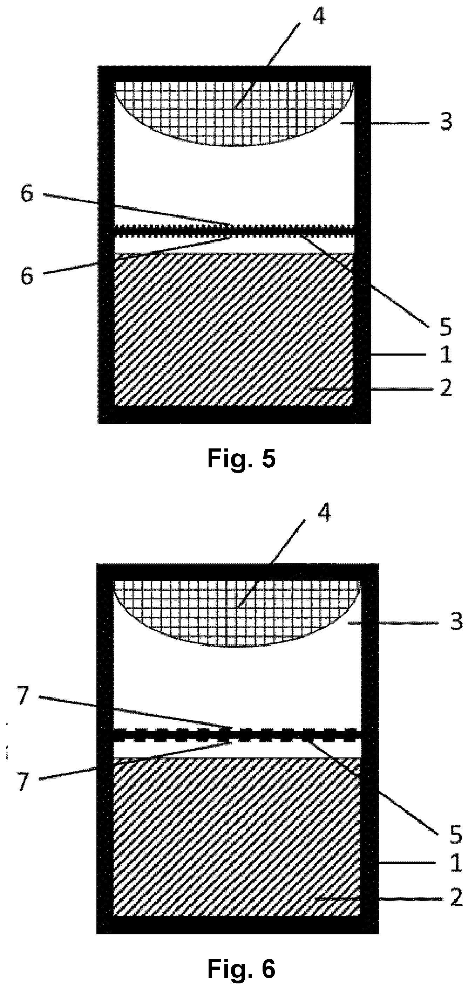

Beim sechsten erfindungsgemäßen Wachstumstiegel gemäß Fig. 5 wird der Gasraum 3 wie beim zweiten erfindungsgemäßen Wachstumstiegel aus dem ersten Gasraum 3a und dem zweiten Gasraum 3b gebildet. Dabei weist nun sowohl die erste als auch die zweite Oberfläche eine im Emissionsgrad ε reduzierte Oberfläche 6 auf. Der reduzierte Emissionsgrad ε führt zu einem erhöhten axialen Temperaturgradienten zwischen dem Quellenmaterial 2 und dem gaspermeablen Trennelement 5 sowie zwischen dem gaspermeablen Trennelement 5 und dem wachsendem Einkristall 4. Dadurch steigt der gesamte axiale Temperaturgradient zwischen dem Quellenmaterial 2 und dem Einkristall 4. Vorteilhafterweise steigen dadurch auch der Wärmestrom und der Stofftransport bzw. der Materialstrom.

Beim siebten erfindungsgemäßen Wachstumstiegel gemäß Fig. 6 wird der Gasraum 3 wiederum aus dem ersten Gasraum 3a und dem zweiten Gasraum 3b gebildet (siehe Fig. 2B). Sowohl die erste als auch die zweite Oberfläche weist nun eine im Emissionsgrad ε erhöhte Oberfläche 7 auf. Der erhöhte Emissionsgrad ε führt zu einem reduzierten axialen Temperaturgradienten zwischen dem Quellenmaterial 2 und dem gaspermeablen Trennelement 5 sowie zwischen dem gaspermeablen Trennelement 5 und dem wachsendem Einkristall 4. Dadurch verringert sich der gesamte axiale Temperaturgradient zwischen dem Quellenmaterial 2 und dem Einkristall 4. Der Wärmestrom und der Stofftransport bzw. der Materialstrom können dadurch verringert werden.

Weiterhin ist es möglich, an der ersten und zweiten Oberfläche jeweils einen unterschiedlichen Emissionsgrad ε vorzusehen. Dadurch kann der Gesamtwärmestrom zwischen Quellenmaterial 2 und Einkristall 4 besonders definiert eingestellt werden. Dadurch kann der axiale Temperaturgradient bis zur Wachstumsgrenzfläche hin definiert eingestellt werden. Der axiale Temperaturgradient bestimmt maßgeblich die Wachstumsrate und Wachstumskinetik (z.B. laterales Überwachsen von Defekten, Erhöhung der SiC Polytypenstabilität).

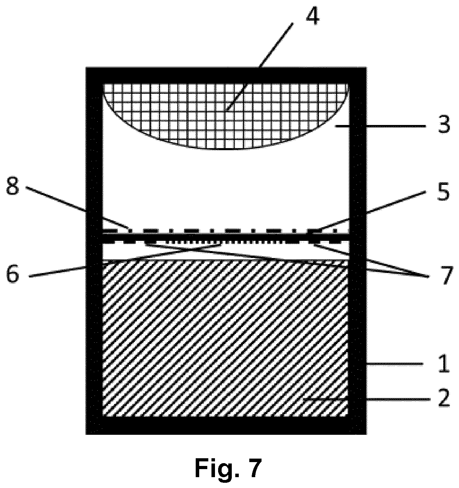

Beim achten erfindungsgemäßen Wachstumstiegel gemäß Fig. 7 wird der Gasraum 3 wiederum aus dem ersten Gasraum 3a und dem zweiten Gasraum 3b gebildet. Die zweite Oberfläche des gaspermeablen Trennelements 5 weist nun einen radial innenliegenden und einen radial außenliegenden Abschnitt auf. Der radial innenliegende und der radial außenliegende Abschnitt sind zueinander konzentrisch angeordnet. Die zweite Oberfläche des gaspermeablen Trennelements 5 ist derart bearbeitet und/oder beschichtet, dass der radial innenliegende Abschnitt eine im Emissionsgrad ε reduzierte Oberfläche 6 aufweist und der radial außenliegende Abschnitt eine im Emissionsgrad ε erhöhte Oberfläche 7 aufweist.

Der erhöhte Emissionsgrad ε im radial außenliegenden Abschnitt im Vergleich zum radial innenliegenden Abschnitt der zweiten Oberfläche des gaspermeablen Trennelements 5 führt zu einem reduzierten axialen Temperaturgradienten im Außenbereich der Grenzfläche des Quellenmaterials 2. Die damit verbundene niedrigere Temperatur im Außenbereich führt zu einem reduzierten Ab-Sublimieren vom Quellenmaterial 2. Das Quellenmaterial 2 wird dadurch gleichmäßiger verbraucht. Dies wirkt sich vorteilhafterweise sehr stabilisierend auf einen langen Kristallwachstumsprozess aus. Der Kristallwachstumsprozess wird dadurch also verbessert.

Weiterhin können beim achten erfindungsgemäßen Wachstumstiegel mehrere konzentrisch angeordnete Abschnitte mit von innen nach außen ansteigendem Emissionsgrad ε an der zweiten Oberfläche des gaspermeablen Trennelements 5 vorgesehen sein. Der Emissionsgrad ε kann dabei graduell ansteigen oder abrupt bei einem oder mehreren radial außenliegenden Abschnitten ansteigen.

Die nun in Fig. 7 mit dem Bezugszeichen 8 versehene erste Oberfläche weist eine definierte Einstellung des Emissionsgrads ε auf. Dabei kann insbesondere eine der bereits oben beschriebenen Ausgestaltungen der ersten Oberfläche 8 vorgesehen sein. Die erste Oberfläche 8 kann insbesondere die gleiche Anordnung wie die zweite Oberfläche aufweisen, vorzugsweise wie in den vorangehenden Absätzen beschrieben aus einem radial innenliegenden Abschnitt und einem diesen Abschnitt konzentrisch umgebenden radial außenliegenden Abschnitt oder aus mehreren zueinander konzentrisch angeordnete Abschnitten. Die Ausgestaltung der ersten Oberfläche 8 und die Ausgestaltung der zweiten Oberfläche können sich jedoch auch unterscheiden. Es versteht sich von selbst, dass das in Fig. 7 an der ersten Oberfläche 8 gezeigte schematische Punkt-Strich-Muster rein illustrativer Natur ist und hier lediglich zur Kennzeichnung einer erfindungsgemäß ausgestalteten ersten Oberfläche 8 verwendet wird.

Alternativ zum achten erfindungsgemäßen Wachstumstiegel kann die Anordnung der im Emissionsgrad ε reduzierten Oberfläche 6 und der im Emissionsgrad ε erhöhten Oberfläche 7 an der zweiten Oberfläche des gaspermeablen Trennelements 5 auch invers vorgenommen sein (nicht gezeigt). Die im Emissionsgrad ε reduzierte Oberfläche 6 kann also im radial außenliegenden Abschnitt und die im Emissionsgrad ε erhöhte Oberfläche 7 kann im radial innenliegenden Abschnitt vorgesehen werden. Diese Maßnahme führt zu einer Erhöhung des axialen Temperaturgradienten im Außenbereich der Oberfläche des Quellenmaterials 2. Die damit verbundene höhere Temperatur im Außenbereich führt jedoch zu einem erhöhten Ab-Sublimieren vom Quellenmaterial 2. Das Quellenmaterial 2 wird dadurch ungleichmäßig verbraucht.

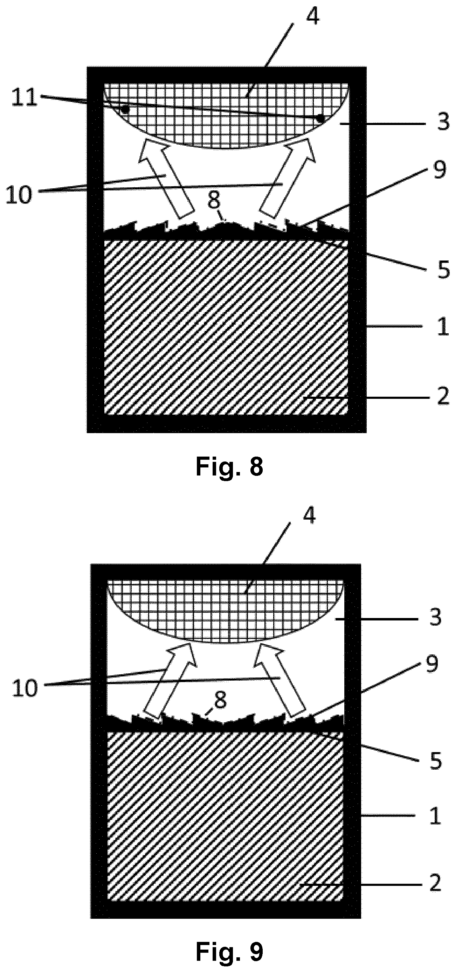

Beim neunten erfindungsgemäßen Wachstumstiegel gemäß Fig. 8 weist die erste Oberfläche 8 ein Relief 9 auf. Beim Vorsehen eines gaspermeablen Trennelements ohne erfindungsgemäße Ausgestaltung, insbesondere ohne Relief, sind die Wärmeströme von der erste Oberfläche 8 in Richtung der Wachstumsgrenzfläche des Einkristalls 4 nach innen gebogen. Dadurch bildet sich die Wachstumsgrenzfläche des Einkristalls 4 in einer konvexen Form aus. Weiterhin werden dadurch radiale Temperaturgradienten verursacht.

Das Relief 9 des neunten erfindungsgemäßen Wachstumstiegels weist einen Sägezahnverlauf mit nach außen gekippten konzentrisch angeordneten Flächen auf. Dadurch werden die Wärmeströme 10 von der ersten Oberfläche 8 aus im Vergleich zu einer Axialrichtung radial nach außen gekippt und kompensieren teilweise die zur Wachstumsgrenzfläche des Einkristalls 4 hin nach innen gerichtete Wärmestromrichtung. Die Gesamtheit der Wärmeströme ist dadurch weniger stark auf das Zentrum des Einkristalls 4 konzentriert. Die Wärmeströme gelangen stattdessen in einem stärkeren Maß zum radial außenliegenden Randbereich des Einkristalls 4 und sorgen dort für eine zusätzliche Erwärmung 11. Dadurch wird also eine Homogenisierung der Temperatur des Einkristalls 4 erreicht. Dies führt zu einer Reduktion des radialen Temperaturgradienten. Dadurch wird also vorteilhafterweise der Kristallwachstumsprozess verbessert.

Beim zehnten erfindungsgemäßen Wachstumstiegel gemäß Fig. 9 weist die erste Oberfläche 8 ein Relief 9 mit einem Sägezahnverlauf mit nach innen gekippten konzentrisch angeordneten Flächen auf. Dadurch werden die Wärmeströme 10 im Vergleich zu einer Axialrichtung verstärkt radial nach innen gekippt. Die Wärmeströme gelangen dadurch in einem stärkeren Maß in das radial innenliegende Zentrum des Einkristalls 4 und bewirken eine verstärkte Abkühlung des radial außenliegenden Bereiches des Einkristalls 4. Dies führt zu einer Erhöhung des radialen Temperaturgradienten.

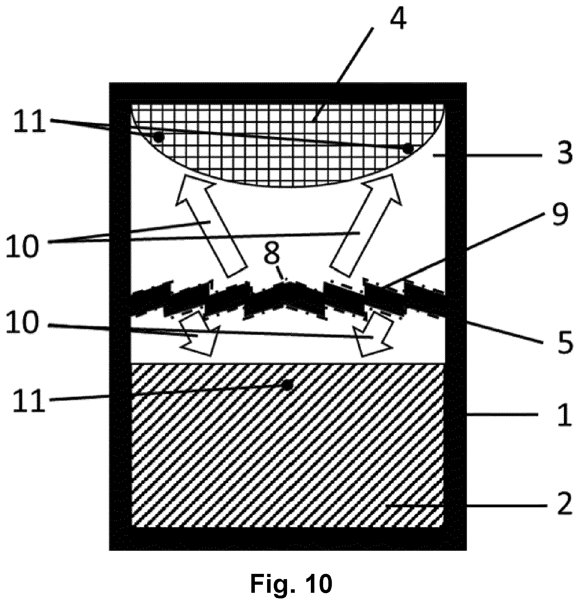

Beim elften erfindungsgemäßen Wachstumstiegel gemäß Fig. 10 wird der Gasraum 3 wie beim zweiten erfindungsgemäßen Wachstumstiegel aus dem ersten Gasraum 3a und dem zweiten Gasraum 3b gebildet. Darüber hinaus weisen sowohl die erste Oberfläche 8 als auch die zweite Oberfläche jeweils ein Relief 9 mit einem Sägezahnverlauf auf. Dabei weist die erste Oberfläche 8 ein Relief 9 mit einem Sägezahnverlauf mit nach außen gekippten konzentrisch angeordneten Flächen auf. Die zweite Oberfläche weist ein Relief 9 mit einem Sägezahnverlauf mit nach innen gekippten konzentrisch angeordneten Flächen. In weiteren Ausführungsformen sind andere Konturen des Reliefs 9 möglich. Beispielsweise kann das Relief eine sinusförmige, dreieckige, rechteckige oder trapezförmige Kontur haben. Im ersten Gasraum 3a werden die Wärmeströme 10 wie beim neunten erfindungsgemäßen Wachstumstiegel von der ersten Oberfläche 8 aus im Vergleich zu einer Axialrichtung radial nach außen gekippt und kompensieren dadurch teilweise die zur Wachstumsgrenzfläche des Einkristalls 4 hin nach innen gerichtete Wärmestromrichtung. Die Wärmeströme gelangen in einem stärkeren Maß zum radial außenliegenden Randbereich des Einkristalls 4 und sorgen dort für eine zusätzliche Erwärmung 11. Dies führt zu einer Reduktion des radialen Temperaturgradienten. Dadurch wird also vorteilhafterweise der Kristallwachstumsprozess verbessert. Durch den nach innen gekippten Sägezahnverlauf an der zweiten Oberfläche werden die Wärmeströme 10 im zweiten Gasraum 3b im Vergleich zu einer Axialrichtung radial nach innen gekippt. Die Wärmeströme gelangen dadurch in einem stärkeren Maß in das radial innenliegende Zentrum des Quellenmaterials 2 und sorgen dort für eine zusätzliche Erwärmung 11. Die damit verbundene höhere Temperatur im radial innenliegenden Zentrum führt zu einem dort erhöhten Ab-Sublimieren vom Quellenmaterial 2. Das Quellenmaterial 2 wird dadurch gleichmäßiger verbraucht. Die radialen Temperaturgradienten im Quellenmaterial 2 haben für ein gleichmäßiges Ab-Sublimieren, vergleichbar zum Fall des wachsenden Einkristalls 4, vorzugsweise einen Betrag von 0,1 K/cm bis 10 K/cm. Dies wirkt sich vorteilhafterweise sehr stabilisierend auf einen langen Kristallwachstumsprozess aus. Der Kristallwachstumsprozess wird also sowohl durch das Relief 9 an der ersten Oberfläche 8 mit radial nach außen gekipptem Sägezahnverlauf als auch durch das Relief 9 an der zweiten Oberfläche mit radial nach innen gekipptem Sägezahnverlauf verbessert.

Alternativ zum elften erfindungsgemäßen Wachstumstiegel kann sowohl die erste Oberfläche 8 als auch die zweite Oberfläche jeweils ein Relief 9 mit einem Sägezahnverlauf mit nach außen gekippten konzentrisch angeordneten Flächen aufweisen (nicht gezeigt). Dadurch werden die Wärmeströme 10 im Vergleich zu einer Axialrichtung radial nach außen gekippt. Die Wärmeströme gelangen dadurch stärker einerseits in die radial außenliegenden Randbereiche des Einkristalls 4 und andererseits in die radial außenliegenden Randbereiche des Quellenmaterials 2. Dadurch wird eine stärkere Erwärmung 11 einerseits der radial außenliegenden Randbereiche des Einkristalls 4 und andererseits der radial außenliegenden Randbereiche des Quellenmaterials 2 bewirkt. Dies führt einerseits zu einer Reduktion des radialen Temperaturgradienten im Bereich der Wachstumsgrenzfläche des Einkristalls 4. Andererseits wird dadurch das Quellenmaterial 2 ungleichmäßiger verbraucht.

Bei vorhandenem zweiten Gasraum 3b zwischen Quellenmaterial 2 und gaspermeablem Trennelement 5 kann also in Richtung des Quellenmaterials 2 durch die lokale Steuerung der Oberflächentemperatur des Quellenmaterials 2 die Sublimationsrate und damit die Konzentration des gasförmigen Vorläufermaterials, insbesondere der Gasspezies aus SiC, lokal angepasst werden. Auf diese Weise kann gerade bei einem großen Durchmesser des wachsenden Einkristalls 4 ein homogener Gasstrom vom Quellenmaterial 2 zum Einkristall 4 realisiert werden.

Das Vorsehen des Reliefs 9 kann mit dem Vorsehen eines vorbestimmten Emissionsgrads ε oder einer vorbestimmten Verteilung verschiedener Emissionsgrade ε kombiniert werden. Eine solche Kombination kann an der ersten Oberfläche 8, an der zweiten Oberfläche oder an beiden Oberflächen des gaspermeablen Trennelements 5 vorgesehen werden. Insbesondere kann eine Kombination mit einer der zum zweiten bis achten erfindungsgemäßen Wachstumstiegel beschriebenen Ausgestaltungen vorgesehen werden. Die mit eines Reliefs 9 versehene erste 8 und/oder zweite Oberfläche kann also zusätzlich eine im Emissionsgrad ε reduzierte Oberfläche 6 und/oder eine im Emissionsgrad ε erhöhte Oberfläche 7 aufweisen. Weiterhin können verschiedene Abschnitte mit unterschiedlichem Emissionsgrad ε auf das jeweilige Relief 9 der ersten 8 und/oder zweiten Oberfläche vorgesehen sein. Es versteht sich wiederum von selbst, dass das in den Figuren 8 bis 10 an der ersten 8 und/oder zweiten Oberfläche gezeigte schematische Punkt-Strich-Muster rein illustrativer Natur ist. Durch eine solche Kombination ist es noch genauer möglich, sowohl den radialen Temperaturgradienten beim wachsenden Einkristall 4 als auch die Temperatur und damit das Ab-Sublimieren des Quellenmaterial 2 zu homogenisieren. Beides trägt zu einer Verbesserung der Wachstumsbedingungen des Einkristalls 4 bei und ist insbesondere bei der Herstellung von Einkristallen 4, insbesondere aus SiC oder AIN, mit großen Durchmessern von 150 mm, 200 mm, 250 mm, 300 mm oder noch größer von großem Nutzen.

Beim zwölften erfindungsgemäßen Wachstumstiegel gemäß Fig. 11 ist eine Manipulatorstange 14 als Stelleinrichtung zur Einstellung der Position des gaspermeablen Trennelements 5 vorgesehen. Die Manipulatorstange 14 ist aus Graphit oder TaC gebildet. Die Manipulatorstange 14 verläuft zentral axial durch das Quellenmaterial 2 hindurch. Die Manipulatorstange 14 ist dabei durch ein zentral axial durch das Quellenmaterial 2 verlaufendes Rohr 12 geführt. Das Quellenmaterial 2 ist als massiver Volumenkörper, insbesondere in Form eines dichten Zylinderblocks aus SiC oder AIN, vorgesehen. Die Manipulatorstange 14 trifft zentral auf die zweite Oberfläche des gaspermeablen Trennelements 5 und ist dort mit dem gaspermeablen Trennelement 5 verbunden. Durch einen freien im Rohr 12 vorgesehenen Raum kann Inertgas in das Innere des Wachstumstiegels eingeleitet werden. Das Einleiten des Inertgases verhindert vorteilhafterweise ein Ausströmen des gasförmigen Vorläufermaterials in den freien Raum. Dadurch kann der Wachstumstiegel also abgedichtet werden.

Die Manipulatorstange 14 kann also in axialer Bewegungsrichtung 15 bewegt werden. Entsprechend kann das gaspermeable Trennelement 5 durch die Bewegung der Manipulatorstange 14 in axialer Bewegungsrichtung 15 bewegt werden. Das gaspermeable Trennelement 5 kann dadurch also dem Quellenmaterial 2 oder dem Einkristall 4 angenähert werden.

Beim dreizehnten erfindungsgemäßen Wachstumstiegel gemäß Fig. 12 ist ein Manipulatorzylinder 16 als Stelleinrichtung zur Einstellung der Position des gaspermeablen Trennelements 5 vorgesehen. Der Manipulatorzylinder 16 ist aus Graphit oder TaC gebildet. Der Manipulatorzylinder 16 ist ein das Quellenmaterial 2 radial umgebender Hohlzylinder. Das Quellenmaterial 2 ist als massiver Volumenkörper, insbesondere in Form eines dichten Zylinderblocks aus SiC oder AIN, vorgesehen. Das gaspermeable Trennelement 5 bildet eine Stirnfläche des Manipulatorzylinders 16. Der äußere Umfang des gaspermeablen Trennelements 5 ist also mit einem Ende des Manipulatorzylinders 16 verbunden. Zwischen dem Manipulatorzylinder 16 und der Tiegelwand 1 ist ein freier Raum vorgesehen. Durch den freien Raum kann Inertgas in das Innere des Wachstumstiegels eingeleitet werden. Das Einleiten des Inertgases verhindert vorteilhafterweise ein Ausströmen des gasförmigen Vorläufermaterials in den freien Raum. Dadurch kann der Wachstumstiegel also abgedichtet werden.

Die Manipulatorzylinder 16 kann also in axialer Bewegungsrichtung 15 bewegt werden. Entsprechend kann das gaspermeable Trennelement 5 durch die Bewegung des Manipulatorzylinders 16 in axialer Bewegungsrichtung 15 bewegt werden. Das gaspermeable Trennelement 5 kann dadurch also dem Quellenmaterial 2 oder dem Einkristall 4 angenähert werden.

Mit Hilfe der als Manipulatorstange 14 oder als Manipulatorzylinder 16 ausgestalteten Stelleinrichtung kann das gaspermeable Trennelement 5 nachgeführt werden. Dadurch können die Wachstumsbedingungen im Gasraum 3 während des Wachstumsprozesses konstant gehalten werden. So kann beispielsweise der Abstand zwischen dem gaspermeablen Trennelement 5 und dem wachsenden Einkristall 4, insbesondere der Abstand zur konvexen Wachstumsgrenzfläche des Einkristalls 4, konstant gehalten werden. Weiterhin kann der Abstand zum Quellenmaterial 2 durch Absenken des gaspermeablen Trennelements 5 konstant gehalten werden.

Das Vorsehen der Manipulatorstange 14 oder des Manipulatorzylinders 16 als Stelleinrichtung zur Einstellung der Position des gaspermeablen Trennelements 5 kann insbesondere mit dem Vorsehen eines vorbestimmten Emissionsgrads ε oder einer vorbestimmten Verteilung verschiedener Emissionsgrade ε und/oder mit dem Vorsehen des Reliefs 9 kombiniert werden. Insbesondere kann eine Kombination des Vorsehens der Manipulatorstange 14 oder des Manipulatorzylinders 16 als Stelleinrichtung mit einer der zum zweiten bis elften erfindungsgemäßen Wachstumstiegel beschriebenen Ausgestaltungen vorgesehen werden. Eine entsprechend bearbeitete, beschichtete und/oder strukturierte erste und/oder zweite Oberfläche des gaspermeablen Trennelements 5 ist in den Fig. 11 und 12 jeweils rein illustrativ angedeutet und mit dem Bezugszeichen 13 versehen. Dadurch kann ein besonders stabiler Wachstumsprozess erreicht werden.

Die hier erläuterten Ausführungsbeispiele gehen jeweils von der in Fig. 1 gezeigten Standardwachstumszelle aus. Es versteht sich jedoch von selbst, dass die erfindungsgemäßen Merkmale auch bei weiteren Wachstumszellen vorgesehen werden können.

### Bezugszeichenliste

- 1: Tiegelwand
- 2: Quellenmaterial
- 3: Gasraum
- 3a: erster Gasraum
- 3b: zweiter Gasraum
- 4: Einkristall
- 5: gaspermeables Trennelement
- 6: im Emissionsgrad ε reduzierte Oberfläche
- 7: im Emissionsgrad ε erhöhte Oberfläche
- 8: erste Oberfläche
- 9: Relief
- 10: Wärmeströme
- 11: zusätzliche Erwärmung
- 12: Rohr
- 13: bearbeitete, beschichtete und/oder strukturierte Oberfläche
- 14: Manipulatorstange
- 15: Bewegungsrichtung
- 16: Manipulatorzylinder

## Patentansprüche

1. Verfahren zur Herstellung und/oder Vergrößerung eines Einkristalls (4) durch Steuerung von Temperaturgradienten in einem zylindrischen Wachstumstiegel,
wobei im Inneren des Wachstumstiegels ein Quellenmaterial (2), der Einkristall (4) und ein zwischen dem Quellenmaterial (2) und dem Einkristall (4) vorgesehenes gaspermeables Trennelement (5) mit einer dem Einkristall (4) zugewandten ersten Oberfläche und einer dem Quellenmaterial (2) zugewandten zweiten Oberfläche aufgenommen sind,
wobei das Verfahren die folgenden Schritte umfasst:
• Aufheizen des Quellenmaterials (2) und des Einkristalls (4), so dass sich ein Temperaturgradient zwischen dem Quellenmaterial (2) und dem Einkristall (4) ausbildet,
• Verdampfen von heißem Quellenmaterial (2) zur Bildung von gasförmigen Vorläufermaterial in der Gasphase,
• Abscheiden des gasförmigen Vorläufermaterials aus der Gasphase am Einkristall (4),
wobei das Quellenmaterial (2) in Abhängigkeit der Temperaturgradienten verdampft, und/oder das gasförmige Vorläufermaterial in Abhängigkeit der Temperaturgradienten transportiert und/oder abgeschieden wird,
wobei die Temperaturgradienten durch die Ausgestaltung der ersten und/oder zweiten Oberfläche des gaspermeablen Trennelements (5) und/oder durch eine Änderung der Position des gaspermeablen Trennelements (5) eingestellt werden, wobei die erste Oberfläche des gaspermeablen Trennelements (5) eine vorbestimmte Verteilung verschiedener Emissionsgrade (ε) und/oder die zweite Oberfläche des gaspermeablen Trennelements (5) eine vorbestimmte Verteilung verschiedener Emissionsgrade (ε) aufweist, **dadurch gekennzeichnet, dass** die Verteilung verschiedener Emissionsgrade (ε) an der ersten und/oder zweiten Oberfläche derart vorbestimmt ist, dass in einem radial innenliegenden Abschnitt ein kleinerer Emissionsgrad (ε) vorgesehen ist als in einem den radial innenliegenden Abschnitt konzentrisch umgebenden radial außenliegenden Abschnitt.

2. Verfahren nach Anspruch 1, wobei die erste Oberfläche des gaspermeablen Trennelements (5) einen vorbestimmten ersten Emissionsgrad (ε) und/oder die zweite Oberfläche des gaspermeablen Trennelements (5) einen vorbestimmten zweiten Emissionsgrad (ε) aufweist.

3. Verfahren nach Anspruch 1,
wobei die vorbestimmte Verteilung verschiedener Emissionsgrade an der ersten Oberfläche des gaspermeablen Trennelements und/oder die vorbestimmte Verteilung verschiedener Emissionsgrade an der zweiten Oberfläche des gaspermeablen Trennelements sich konzentrisch umgebende Abschnitte von unterschiedlichem Emissionsgrad aufweist,
wobei die Verteilung verschiedener Emissionsgrade an der ersten und/oder zweiten Oberfläche vorzugsweise derart vorbestimmt ist, dass in radialer Erstreckung des gaspermeablen Trennelements innen ein kleinerer Emissionsgrad resultiert als außen.

4. Verfahren nach einem der vorangehenden Ansprüche, wobei die erste Oberfläche des gaspermeablen Trennelements (5) ein vorbestimmtes erstes Relief und/oder die zweite Oberfläche des gaspermeablen Trennelements (5) ein vorbestimmtes zweites Relief aufweist,
wobei das erste und/oder das zweite Relief vorzugsweise gekrümmte und/oder zueinander verkippte Flächen aufweist,
wobei die Flächen vorzugsweise konzentrisch angeordnet sind, und
wobei das erste und/oder das zweite Relief vorzugsweise einen Sägezahnverlauf aufweist, wobei besonders bevorzugt das erste Relief einen Sägezahnverlauf mit nach außen gekippten konzentrisch angeordneten Flächen aufweist und/oder das zweite Relief einen Sägezahnverlauf mit nach innen gekippten konzentrisch angeordneten Flächen aufweist.

5. Verfahren nach einem der vorangehenden Ansprüche, wobei die erste Oberfläche und die zweite Oberfläche des gaspermeablen Trennelements (5) den gleichen vorbestimmten Emissionsgrad (ε) oder sich unterscheidende vorbestimmte Emissionsgrade (ε) aufweisen, und/oder die gleiche vorbestimmte Verteilung verschiedener Emissionsgrade (ε) oder sich unterscheidende vorbestimmte Verteilungen verschiedener Emissionsgrade (ε) aufweisen, und/oder das gleiche vorbestimmte Relief oder sich unterscheidende vorbestimmte Reliefs aufweisen.

6. Verfahren nach einem der vorangehenden Ansprüche, wobei weitere konzentrische Abschnitte mit sich in radial nach außen gerichteter Richtung kontinuierlich oder diskret erhöhenden Emissionsgraden (ε) zwischen dem radial innenliegenden Abschnitt und dem radial außenliegenden Abschnitt vorgesehen sind.

7. Wachstumstiegel zur Herstellung und/oder Vergrößerung eines Einkristalls (4), insbesondere durch ein Verfahren zur Herstellung und/oder Vergrößerung eines Einkristalls nach einem der Ansprüche 1 bis 6,
wobei der Wachstumstiegel zylindrisch ist, eine Tiegelwand (1) aufweist und in seinem Inneren ein Quellenmaterial (2), den Einkristall (4) und ein zwischen dem Quellenmaterial (2) und dem Einkristall (4) vorgesehenes gaspermeables Trennelement (5) mit einer dem Einkristall (4) zugewandten ersten Oberfläche und einer dem Quellenmaterial (2) zugewandten zweiten Oberfläche umfasst, wobei der Wachstumstiegel zur Steuerung von Temperaturgradienten ausgebildet ist,
wobei ein Temperaturgradient zwischen dem Quellenmaterial (2) und dem Einkristall (4) durch Aufheizen des Quellenmaterials (2) und des Einkristalls (4) ausbildbar ist, wobei gasförmiges Vorläufermaterial in der Gasphase durch Verdampfen von heißem Quellenmaterial (2) bildbar ist, in der Gasphase transportiert wird, und aus der Gasphase am Einkristall (4) abscheidbar ist, wobei das Verdampfen und/oder der Transport und/oder das Abscheiden des gasförmigen Vorläufermaterials in Abhängigkeit der Temperaturgradienten erfolgt,
wobei die Temperaturgradienten durch die Ausgestaltung der ersten und/oder zweiten Oberfläche des gaspermeablen Trennelements (5) und/oder durch eine Änderung der Position des gaspermeablen Trennelements (5) einstellbar sind,
wobei die erste Oberfläche des gaspermeablen Trennelements (5) eine vorbestimmte Verteilung verschiedener Emissionsgrade (ε) und/oder die zweite Oberfläche des gaspermeablen Trennelements (5) eine vorbestimmte Verteilung verschiedener Emissionsgrade (ε) aufweist, **dadurch gekennzeichnet, dass** die Verteilung verschiedener Emissionsgrade (ε) an der ersten und/oder zweiten Oberfläche derart vorbestimmt ist, dass in einem radial innenliegenden Abschnitt ein kleinerer Emissionsgrad (ε) vorgesehen ist als in einem den radial innenliegenden Abschnitt konzentrisch umgebenden radial außenliegenden Abschnitt.

8. Wachstumstiegel nach Anspruch 7, wobei der Wachstumstiegel eine Stelleinrichtung zur Einstellung der Position des gaspermeablen Trennelements (5) aufweist.

9. Wachstumstiegel nach Anspruch 7 oder 8, wobei das gaspermeable Trennelement (5) als eine Platte, als eine Membran oder als ein Gitter ausgestaltet ist.

10. Wachstumstiegel nach einem der Ansprüche 7 bis 9, wobei das gaspermeable Trennelement (5) aus einem Metallkarbid und/oder Metallkarbidschaum, insbesondere aus TaC und/oder TaC-Schaum gebildet ist.

11. Wachstumstiegel nach einem der Ansprüche 7 bis 10, wobei als Quellenmaterial (2) SiC, vorzugsweise ein SiC-Pulver und/oder ein SiC-Volumenkörper, vorgesehen ist.

12. Wachstumstiegel nach einem der Ansprüche 7 bis 11, wobei die Tiegelwand (1) aus Graphit und/oder Ta und/oder TaC und/oder beschichtetem Graphit, insbesondere aus pyrolytisch mit Kohlenstoff beschichtetem Graphit und/oder aus mit Ta und/oder TaC beschichtetem Graphit, gebildet ist.

13. Wachstumstiegel nach einem der Ansprüche 7 bis 12, wobei der Wachstumstiegel eine Heizvorrichtung zum Aufheizen des Quellenmaterials (2) und/oder des Einkristalls (4) umfasst, wobei die Heizvorrichtung vorzugsweise eine induktive Heizeinheit und/oder eine Widerstandsheizeinheit umfasst.

## Claims

1. Method for producing and/or enlarging a single crystal (4) by controlling temperature gradients in a cylindrical crucible,
wherein the inside of the crucible contains a source material (2), the single crystal (4), and a gas-permeable separating element (5) provided between the source material (2) and the single crystal (4), with a first surface facing the single crystal (4) and a second surface facing the source material (2),
wherein the method comprises the following steps:
• Heating the source material (2) and the single crystal (4) so that a temperature gradient forms between the source material (2) and the single crystal (4),
• Evaporating hot source material (2) to form gaseous precursor material in the gas phase,
• Depositing the gaseous precursor material from the gas phase on the single crystal (4),
wherein the source material (2) evaporates depending on the temperature gradients, and/or the gaseous precursor material is transported and/or deposited depending on the temperature gradients,
wherein the temperature gradients are set by the configuration of the first and/or second surface of the gas-permeable separating element (5) and/or by changing the position of the gas-permeable separating element (5), wherein the first surface of the gas-permeable separating element (5) has a predetermined distribution of different emissivities (ε) and/or the second surface of the gas-permeable separating element (5) has a predetermined distribution of different emissivities (ε),
**characterized in that**
the distribution of different emissivities (ε) on the first and/or second surface is predetermined such that a lower emissivity (ε) is provided in a radially inner section than in a radially outer section that concentrically surrounds the radially inner section.

2. Method according to claim 1, wherein the first surface of the gas-permeable separating element (5) has a predetermined first emissivity (ε) and/or the second surface of the gas-permeable separating element (5) has a predetermined second emissivity (ε).

3. Method according to claim 1,
wherein the predetermined distribution of different emissivities on the first surface of the gas-permeable separation element and/or the predetermined distribution of different emissivities on the second surface of the gas-permeable separation element comprises concentric, surrounding sections with different emissivity,
wherein the distribution of different emissivities on the first and/or second surface is preferably predetermined such that, along the radial extension of the gas-permeable separating element, the emissivity is lower on the inside than on the outside.

4. Method according to one of the preceding claims, wherein the first surface of the gas-permeable separating element (5) has a predetermined first relief and/or the second surface of the gas-permeable separating element (5) has a predetermined second relief,
wherein the first and/or the second relief preferably has curved and/or mutually tilted surfaces,
wherein the surfaces are preferably arranged concentrically, and
wherein the first and/or the second relief preferably has a sawtooth profile, wherein, particularly preferable, the first relief has a sawtooth profile with concentrically arranged surfaces tilted outward, and/or the second relief has a sawtooth profile with concentrically arranged surfaces tilted inward.

5. Method according to one of the preceding claims, wherein the first surface and the second surface of the gas-permeable separating element (5) have the same predetermined emissivity (ε) or different predetermined emissivities (ε), and/or have the same predetermined distribution of different emissivities (ε) or different predetermined distributions of different emissivities (ε), and/or have the same predetermined relief or different predetermined reliefs.

6. Method according to one of the preceding claims, wherein further concentric sections with emissivities (ε) that increase continuously or discretely in a radially outward direction are provided between the radially inner section and the radially outer section.

7. Crucible for producing and/or enlarging a single crystal (4), in particular by a method for producing and/or enlarging a single crystal according to one of claims 1 to 6,
wherein the crucible is cylindrical, has a crucible wall (1) and comprises in its interior a source material (2), the single crystal (4), and a gas-permeable separating element (5) provided between the source material (2) and the single crystal (4), with a first surface facing the single crystal (4) and a second surface facing the source material (2),
wherein the crucible is designed to control temperature gradients,
wherein a temperature gradient between the source material (2) and the single crystal (4) is formable by heating the source material (2) and the single crystal (4), wherein gaseous precursor material is formable in the gas phase by evaporating hot source material (2), is transported in the gas phase, and is depositable from the gas phase on the single crystal (4),
wherein the vaporization and/or the transport and/or the deposition of the gaseous precursor material takes place depending on the temperature gradients,
wherein the temperature gradients are settable by the configuration of the first and/or second surface of the gas-permeable separating element (5) and/or by changing the position of the gas-permeable separating element (5),
wherein the first surface of the gas-permeable separating element (5) has a predetermined distribution of different emissivities (ε) and/or the second surface of the gas-permeable separating element (5) has a predetermined distribution of different emissivities (ε),
**characterized in that**
the distribution of different emissivities (ε) on the first and/or second surface is predetermined such that a lower emissivity (ε) is provided in a radially inner section than in a radially outer section that concentrically surrounds the radially inner section.

8. Crucible according to claim 7, wherein the crucible comprises an adjustment device for adjusting the position of the gas-permeable separating element (5).

9. Crucible according to claim 7 or 8, wherein the gas-permeable separating element (5) is configured as a plate, a membrane, or a grid.

10. Crucible according to one of claims 7 to 9, wherein the gas-permeable separating element (5) is formed from a metal carbide and/or metal carbide foam, in particular from TaC and/or TaC foam.

11. Crucible according to one of claims 7 to 10, wherein SiC, preferably an SiC powder and/or a solid SiC body, is provided as source material (2).

12. Crucible according to one of claims 7 to 11, wherein the crucible wall (1) is formed of graphite and/or Ta and/or TaC and/or coated graphite, in particular graphite coated with carbon by pyrolysis and/or graphite coated with Ta and/or TaC.

13. Crucible according to one of claims 7 to 12, wherein the crucible comprises a heating device for heating the source material (2) and/or the single crystal (4), and wherein the heating device preferably comprises an inductive heating unit and/or a resistance-heating unit.

## Revendications

1. Procédé de production et/ou d'agrandissement d'un monocristal (4) par contrôle des gradients de température dans un creuset cylindrique,
à l'intérieur du creuset se trouvant un matériau source (2), le monocristal (4) et un élément de séparation (5) perméable aux gaz disposé entre le matériau source (2) et le monocristal (4), présentant une première surface tournée vers le monocristal (4) et une deuxième surface tournée vers le matériau source (2),
le procédé comprenant les étapes suivantes:
• Chauffage du matériau source (2) et du monocristal (4) de manière à créer un gradient de température entre le matériau source (2) et le monocristal (4),
• Vaporisation d'un matériau source (2) chaud pour former un précurseur gazeux en phase gazeuse,
• Dépôt du précurseur gazeux à partir de la phase gazeuse sur le monocristal (4),
le matériau source (2) étant évaporé en fonction des gradients de température, et/ou le matériau précurseur gazeux étant transporté et/ou déposé en fonction des gradients de température,
les gradients de température étant réglés par la configuration de la première et/ou de la deuxième surface de l'élément de séparation (5) perméable aux gaz et/ou par une modification de la position de l'élément de séparation (5) perméable aux gaz, la première surface de l'élément de séparation (5) perméable aux gaz présentant une répartition prédéterminée de différentes émissivités (ε) et/ou la deuxième surface de l'élément de séparation (5) perméable aux gaz présentant une répartition prédéterminée de différentes émissivités (ε),
**caractérisé en ce que**
la répartition des différentes émissivités (ε) sur la première et/ou la deuxième surface est prédéterminée de telle sorte qu'une émissivité (ε) plus faible soit prévue dans une section située radialement à l'intérieur que dans une section située radialement à l'extérieur et entourant concentriquement ladite section située radialement à l'intérieur.

2. Procédé selon la revendication 1, dans lequel la première surface de l'élément de séparation (5) perméable aux gaz présente une première émissivité (ε) prédéterminée et/ou la deuxième surface de l'élément de séparation (5) perméable aux gaz présente une deuxième émissivité (ε) prédéterminée.

3. Procédé selon la revendication 1,
la répartition prédéterminée des différentes émissivités sur la première surface de l'élément de séparation perméable aux gaz et/ou la répartition prédéterminée des différentes émissivités sur la deuxième surface de l'élément de séparation perméable aux gaz comportant des sections entourées concentriquement les unes des autres et présentant des émissivités différentes, la répartition des différentes émissivités sur la première et/ou la deuxième surface étant de préférence prédéterminée de telle sorte que, dans le sens radial de l'élément de séparation perméable aux gaz, l'émissivité soit plus faible à l'intérieur qu'à l'extérieur.

4. Procédé selon l'une des revendications précédentes, dans lequel la première surface de l'élément de séparation (5) perméable aux gaz présente un premier relief prédéterminé et/ou la deuxième surface de l'élément de séparation (5) perméable aux gaz présente un deuxième relief prédéterminé, le premier et/ou le deuxième relief présentant de préférence des faces courbes et/ou inclinées l'une par rapport à l'autre,
les faces étant de préférence disposées de manière concentrique, et
le premier et/ou le deuxième relief présentant de préférence un profil en dents de scie, le premier relief présentant de manière particulièrement préférée un profil en dents de scie avec des faces disposées de manière concentrique et inclinées vers l'extérieur et/ou le deuxième relief présentant de manière particulièrement préférée un profil en dents de scie avec des faces disposées de manière concentrique et inclinées vers l'intérieur.

5. Procédé selon l'une des revendications précédentes, dans lequel la première surface et la deuxième surface de l'élément de séparation (5) perméable aux gaz présentent le même degré d'émissivité prédéterminé (ε) ou des degrés d'émissivité prédéterminés différents (ε), et/ou présentent la même répartition prédéterminée de différents degrés d'émissivité (ε) ou des répartitions prédéterminées différentes de différents degrés d'émissivité (ε), et/ou présentent le même relief prédéterminé ou des reliefs prédéterminés différents.

6. Procédé selon l'une des revendications précédentes, dans lequel d'autres sections concentriques, présentant des émissivités (ε) croissantes de manière continue ou discontinue dans une direction radiale vers l'extérieur, sont prévues entre la section située radialement à l'intérieur et la section située radialement à l'extérieur.

7. Creuset destiné à la production et/ou à l'agrandissement d'un monocristal (4), en particulier selon un procédé de production et/ou d'agrandissement d'un monocristal selon l'une des revendications 1 à 6,
le creuset étant cylindrique, comportant une paroi (1) du creuset et comprenant en son intérieur un matériau source (2), le monocristal (4) et un élément de séparation (5) perméable aux gaz, prévu entre le matériau source (2) et le monocristal (4), présentant une première surface tournée vers le monocristal (4) et une deuxième surface tournée vers le matériau source (2),
le creuset étant conçu pour contrôler des gradients de température,
un gradient de température pouvant être créé entre le matériau source (2) et le monocristal (4) par chauffage du matériau source (2) et du monocristal (4), un matériau précurseur gazeux pouvant être formé en phase gazeuse par évaporation du matériau source (2) chauffé, être transporté en phase gazeuse et se déposer à partir de la phase gazeuse sur le monocristal (4),
l'évaporation et/ou le transport et/ou le dépôt du précurseur gazeux s'effectuant en fonction des gradients de température,
les gradients de température étant réglables par la configuration de la première et/ou de la deuxième surface de l'élément de séparation (5) perméable aux gaz et/ou par une modification de la position de l'élément de séparation (5) perméable aux gaz,
la première surface de l'élément de séparation (5) perméable aux gaz présentant une répartition prédéterminée de différentes émissivités (ε) et/ou la deuxième surface de l'élément de séparation (5) perméable aux gaz présentant une répartition prédéterminée de différentes émissivités (ε),
**caractérisé en ce que**
la répartition des différentes émissivités (ε) sur la première et/ou la deuxième surface est prédéterminée de telle sorte qu'une émissivité (ε) plus faible soit prévue dans une section située radialement à l'intérieur que dans une section située radialement à l'extérieur et entourant concentriquement ladite section située radialement à l'intérieur.

8. Creuset selon la revendication 7, le creuset comportant un dispositif de réglage permettant d'ajuster la position de l'élément de séparation (5) perméable aux gaz.

9. Creuset selon la revendication 7 ou 8, dans lequel l'élément de séparation (5) perméable aux gaz se présente sous la forme d'une plaque, d'une membrane ou d'une grille.

10. Creuset selon l'une des revendications 7 à 9, dans lequel l'élément de séparation (5) perméable aux gaz est constitué d'un carbure métallique et/ou d'une mousse de carbure métallique, en particulier de TaC et/ou de mousse de TaC.

11. Creuset selon l'une des revendications 7 à 10, dans lequel le matériau source (2) est du SiC, de préférence une poudre de SiC et/ou un corps volumique en SiC.

12. Creuset selon l'une des revendications 7 à 11, dans lequel la paroi (1) du creuset est constituée de graphite et/ou de Ta et/ou de TaC et/ou de graphite revêtu, en particulier de graphite revêtu de carbone par pyrolyse et/ou de graphite revêtu de Ta et/ou de TaC.

13. Creuset selon l'une des revendications 7 à 12, le creuset comprenant un dispositif de chauffage destiné à chauffer le matériau source (2) et/ou le monocristal (4), le dispositif de chauffage comprenant de préférence une unité de chauffage par induction et/ou une unité de chauffage par résistance.
